(19) Europäisches Patentamt
European Patent Office
Office européen des brevets

(11) EP 3 213 915 B1

(12) **EUROPEAN PATENT SPECIFICATION**

(45) Date of publication and mention of the grant of the patent:
**14.08.2019 Bulletin 2019/33**

(21) Application number: **15854247.2**

(22) Date of filing: **29.10.2015**

(51) Int Cl.:
***C08G 77/442*** (2006.01) ***C08J 7/04*** (2006.01)
***B32B 27/30*** (2006.01)

(86) International application number:
**PCT/JP2015/080557**

(87) International publication number:
**WO 2016/068236 (06.05.2016 Gazette 2016/18)**

(54) **LAMINATE**

LAMINAT

STRATIFIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.10.2014 JP 2014221431**

(43) Date of publication of application:
**06.09.2017 Bulletin 2017/36**

(73) Proprietor: **DIC Corporation**
**Tokyo 174-8520 (JP)**

(72) Inventors:
- **TAKADA, Yasuhiro**
**Sakura-shi**
**Chiba 285-8668 (JP)**
- **MIKI, Takayuki**
**Sakura-shi**
**Chiba 285-8668 (JP)**
- **YAGI, Naoto**
**Sakura-shi**
**Chiba 285-8668 (JP)**
- **OKA, Kenichiro**
**Sakura-shi**
**Chiba 285-8668 (JP)**
- **TORII, Hideki**
**Sakura-shi**
**Chiba 285-8668 (JP)**
- **KUDO, Shinichi**
**Sakura-shi**
**Chiba 285-8668 (JP)**

(74) Representative: **TBK**
**Bavariaring 4-6**
**80336 München (DE)**

(56) References cited:
**WO-A1-2012/008415**
**WO-A1-2013/125574**
**WO-A1-2014/061630**
**WO-A1-2014/061630**
**JP-A- H10 182 980**
**JP-A- 2006 335 947**
**JP-A- 2011 105 903**
**JP-A- 2011 200 780**
**JP-A- 2013 035 275**
**JP-A- 2013 129 778**
**JP-A- 2015 093 400**
**JP-A- 2015 147 889**
**JP-A- 2015 187 186**
**JP-A- 2015 203 076**
**US-A1- 2013 172 463**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### Technical Field

The present invention relates to a layered body including a resin layer (I) and a second layer (II) that are stacked on one another.

### Background Art

Under severe conditions such as outdoors, protective films play an important role in protecting products. In particular, in automobiles exposed directly to sunlight, abrasion by a car wash, etc., it is essential that a high performance protective film be formed because abrasion resistance, water resistance, and weather resistance comparable to those of glass are required in order to prevent windshield wiper scratches and provide durability under long-term exposure to the outdoors.

In particular, transparent plastic materials recently receiving attention as alternatives to glass are lightweight and highly recyclable and are expected to be used not only for automobiles but also for building exteriors, solar battery components, etc. However, problems with the transparent plastic materials are that their surface is susceptible to abrasion and that yellowing due to ultraviolet light is likely to occur. Therefore, there are expectations for protective films capable of appropriately protecting the plastic.

For example, PTL 1 and PTL 2 disclose layered bodies in which a cured coating layer formed of a specific active energy ray-curable primer composition and an inorganic material layer formed by a chemical vapor deposition method are stacked successively on a resin substrate.

Since the cured coating layer formed of the specific active energy ray-curable primer composition is included, initial adhesion and weather resistance are improved. However, a sufficient level of adhesion to the resin substrate is not achieved when only a silsesquioxane compound and a photopolymerization initiator, which are essential components in PTL 1, are used. In PTL 2, since no silsesquioxane compound is contained, the adhesion to the inorganic material layer is not at a sufficient level.

PTL 3 relates to a dispersing agent for forming an inorganic particle dispersion liquid used in coating material (paint) for forming hardened material on a substrate. The inorganic fine particle dispersant comprises a compound resin (A) in which a polysiloxane segment (a1) having a structural unit represented by general formula (1) and/or general formula (2) and a silanol group and/or a hydrolyzable silyl group is bonded to a vinyl-based polymer segment (a2) through a bond represented by general formula (3), the bond being formed as a result of a dehydration condensation reaction between the silanol group and/or hydrolyzable silyl group of the polysiloxane segment (a1) and a silanol group and/or hydrolyzable silyl group of the vinyl-based polymer segment (a2) (see claim 1).

### Citation List

#### Patent Literature

PTL 1: Japanese Unexamined Patent Application Publication No. 2013-35274
PTL 2: Japanese Unexamined Patent Application Publication No. 2013-35275
PTL 3: US 2013/172463

### Summary of Invention

#### Technical Problem

An object of the present invention is to provide a layered body excellent in abrasion resistance, long-term weather resistance (prevention of yellowing and adhesion), heat-resistant adhesion, and water-resistant adhesion. Solution to Problem

The present inventors have conducted extensive studies and found a layered body excellent in abrasion resistance and long-term weather resistance (prevention of yellowing and adhesion) and also excellent in heat-resistant adhesion and water-resistant adhesion. In this layered body, a resin layer (I) containing a fine inorganic particle composite (M) in which fine inorganic particles (m) are bonded to a composite resin (A) including a polysiloxane segment (a1) and a vinyl-based polymer segment (a2) is stacked on a second layer (II).

Accordingly, the present invention provides a layered body comprising a resin layer (I) and a second layer (II)

that are stacked on one another, wherein the resin layer (I) is formed of a resin composition containing a fine inorganic particle composite (M) that includes:

a composite resin (A) in which a polysiloxane segment (a1) having a structural unit represented by general formula (1) and/or general formula (2) and further having a silanol group and/or a hydrolyzable silyl group is bonded to a vinyl-based polymer segment (a2) through a bond represented by general formula (4); and
fine inorganic particles (m) that are each bonded to the composite resin (A) at the polysiloxane segment (a1) through a siloxane bond:

[Chem. 1]

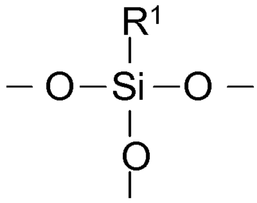

(1)

[Chem. 2]

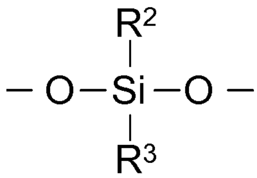

(2)

(wherein, in general formulas (1) and (2), $R^1$, $R^2$, and $R^3$ are each independently an alkyl group having 1 to 6 carbon atoms, a cycloalkyl group having 3 to 8 carbon atoms, an aryl group, an aralkyl group having 7 to 12 carbon atoms, an epoxy group, or a polymerizable double bond-containing group selected from the group consisting of $-R^4-CH=CH_2$, $-R^4-C(CH_3)=CH_2$, $-R^4-O-CO-C(CH_3)=CH_2$, $-R^4-O-CO-CH=CH_2$, and a group represented by formula (3) below (wherein $R^4$ represents a single bond or an alkylene group having 1 to 6 carbon atoms):

[Chem. 3]

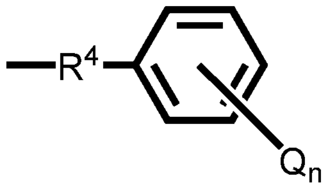

(3)

(wherein, in general formula (3), n is an integer from 1 to 5, and a structure Q represents one of $-CH=CH_2$ and $-C(CH_3)=CH_2$));

[Chem. 4]

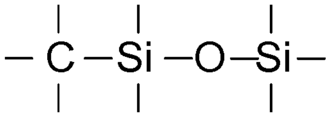

(4)

(wherein, in general formula (4), a carbon atom forms part of the vinyl-based polymer segment (a2), and a silicon atom bonded only to an oxygen atom forms part of the polysiloxane segment (a1)).

The present invention also provides a layered body further comprising a third layer (III), the resin layer (I) and the second layer (II) being disposed in this order on the third layer (III).

The present invention also provides a layered body in which the second layer (II) has a surface formed of an inorganic oxide layer.

The present invention also provides a layered body in which the fine inorganic particles (m) are formed of silica.

Advantageous Effects of Invention

The layered body of the present invention in which the resin layer (I) and the second layer (II) are disposed in this order can be preferably used as a protective film excellent in abrasion resistance and weather resistance. In the layered body in which the resin layer (I) and the second layer (II) are disposed in this order on the third layer (III), the third layer (III) can be protected. The resin layer (I) is interposed between the second layer (II) and the third layer (III) and improves the adhesion of the second layer (II) to the third layer (III), and therefore the second layer (II) is unlikely to be delaminated even when the layered body is used under severe conditions such as the outdoors for a long time.

In the fine inorganic particle composite (M) contained in the curable resin composition in the present invention, the composite resin is bonded directly to the fine inorganic particles (m), and therefore excellent heat resistance and water resistance are achieved. The layered body of the present application is excellent in hard coating properties, heat resistance, water resistance, weather resistance, and light fastness and can therefore be used particularly preferably as various protective materials. For example, the layered body can be used for building materials, household appliances, transporters such as automobiles, ships, airplanes, and railroad cars, electronic materials, recording materials, optical materials, lighting fixtures, packaging materials, protection of outdoor installations, coatings for optical fibers, protection of resin glass, etc. Description of Embodiments

(Layered body)

The layered body of the present invention is a layered body including a resin layer (I) and a second layer (II) that are stacked on one another. The resin layer (I) contains a fine inorganic particle composite (M) that includes: a composite resin (A) in which a polysiloxane segment (a1) having a structural unit represented by general formula (1) and/or general formula (2) and further having a silanol group and/or a hydrolyzable silyl group is bonded to a vinyl-based polymer segment (a2) through a bond represented by general formula (4); and fine inorganic particles (m) that are each bonded to the composite resin (A) at the polysiloxane segment (a1) through a siloxane bond.

In the layered body of the present invention, the resin layer (I) and the second layer (II) may be disposed in this order on a third layer (III). In this case, a layered body including the resin layer (I) and the second layer (II) may be first produced, and then the layered body may be stacked on the third layer (III) with, for example, an adhesive. Alternatively, for example, a layered body including the resin layer (I) and the second layer (II) is first prepared such that the resin layer (I) is uncured or semi-cured.

Then the layered body is brought into contact with the third layer (III), and the resin layer (I) is cured and used as an adhesive. Alternatively, for example, the resin layer (I) is formed on the third layer (III) by being applied and cured, and then the second layer (II) is formed.

(Resin layer (I))

In the layered body of the present invention, the fine inorganic particle composite (M), which is an essential component of the resin composition forming the resin layer (I), is characterized in that the fine inorganic particles (m) are each bonded to the composite resin (A) through the polysiloxane segment (a1).

(Fine inorganic particle composite (M) - composite resin (A))

The composite resin (A) used in the present invention is characterized in that the polysiloxane segment (a1) having the structural unit represented by general formula (1) and/or general formula (2) and further having a silanol group and/or a hydrolyzable silyl group (hereinafter referred to simply as the polysiloxane segment (a1)) is bonded to the vinyl-based polymer segment (a2) through the bond represented by general formula (4).

[Composite resin (A) Polysiloxane segment (a1)]

The composite resin (A) in the present invention includes the polysiloxane segment (a1). The polysiloxane segment (a1) is a segment obtained by condensation of a silane compound having a silanol group and/or a hydrolyzable silyl group. The polysiloxane segment (a1) has the structural unit represented by general formula (1) and/or general formula (2) and further has a silanol group and/or a hydrolyzable silyl group.

Preferably, the content of the polysiloxane segment (a1) is 10 to 90% by weight with respect to the total weight of solids in the composite resin (A). This is because, in this case, the polysiloxane segment (a1) can be easily bonded to the fine inorganic particles (m) described later and the composite resin (A) itself is excellent in abrasion resistance,

weather resistance, heat resistance, and water resistance.

(Structural unit represented by general formula (1) and/or general formula (2))

Specifically, the polysiloxane segment in the present invention has a structural unit represented by the following general formulas (1) and/or (2) and further has a silanol group and/or a hydrolyzable silyl group:

[Chem. 5]

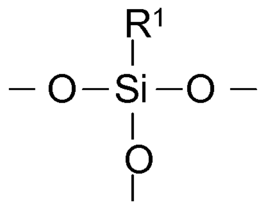

(1)

[Chem. 6]

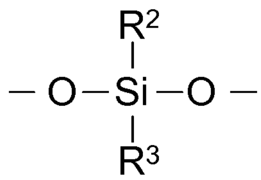

(2)

In general formulas (1) and (2), $R^1$, $R^2$, and $R^3$ are each independently an alkyl group having 1 to 6 carbon atoms, a cycloalkyl group having 3 to 8 carbon atoms, an aryl group, an aralkyl group having 7 to 12 carbon atoms, an epoxy group, or a polymerizable double bond-containing group selected from the group consisting of $-R^4-CH=CH_2$, $-R^4-C(CH_3)=CH_2$, $-R^4-O-CO-C(CH_3)=CH_2$, $-R^4-O-CO-CH=CH_2$, and a group represented by formula (3) below (wherein $R^4$ represents a single bond or an alkylene group having 1 to 6 carbon atoms):

[Chem. 7]

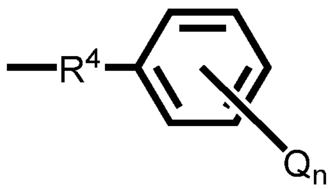

(3)

(In general formula (3), n is an integer from 1 to 5, and a structure Q is one of $-CH=CH_2$ and $-C(CH_3)=CH_2$.)

The structural unit represented by general formula (1) and/or general formula (2) is a three-dimensionally networked polysiloxane structural unit in which two or three bonds of silicon are involved in crosslinking. Although the three-dimensional network structure is formed, the network structure formed is not dense. Therefore, gelation etc. do not occur, and good storage stability is obtained.

Example of the alkylene group having 1 to 6 carbon atoms that is represented by $R^4$ in $R^1$, $R^2$, and $R^3$ in general formulas (1) and (2) include a methylene group, an ethylene group, a propylene group, an isopropylene group, a butylene group, an isobutylene group, a sec-butylene group, a tert-butylene group, a pentylene group, an isopentylene group, a neopentylene group, a tert-pentylene group, a 1-methylbutylene group, a 2-methylbutylene group, a 1,2-dimethylpropylene group, a 1-ethylpropylene group, a hexylene group, an isohexylene group, a 1-methylpentylene group, a 2-methylpentylene group, a 3-methylpentylene group, a 1,1-dimethylbutylene group, a 1,2-dimethylbutylene group, a 2,2-dimethylbutylene group, a 1-ethylbutylene group, a 1,1,2-trimethylpropylene group, a 1,2,2-trimethylpropylene group, a 1-ethyl-2-methylpropylene group, and a 1-ethyl-1-methylpropylene group. Of these, $R^4$ is preferably a single bond or an alkylene group having 2 to 4 carbon atoms in terms of availability of raw materials.

Examples of the alkyl group having 1 to 6 carbon atoms include a methyl group, an ethyl group, a propyl group, an isopropyl group, a butyl group, an isobutyl group, a sec-butyl group, a tert-butyl group, a pentyl group, an isopentyl group, a neopentyl group, a tert-pentyl group, a 1-methylbutyl group, a 2-methylbutyl group, a 1,2-dimethylpropyl group, a 1-ethylpropyl group, a hexyl group, an isohexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1-ethylbutyl group, a 1,1,2-trimethylpropyl group, a 1,2,2-trimethylpropyl group, a 1-ethyl-2-methylpropyl group, and a 1-ethyl-1-methylpropyl group.

Examples of the cycloalkyl group having 3 to 8 carbon atoms include a cyclopropyl group, a cyclobutyl group, a cyclopentyl group, and a cyclohexyl group.

Examples of the aryl group include a phenyl group, a naphthyl group, a 2-methylphenyl group, a 3-methylphenyl group, a 4-methylphenyl group, a 4-vinylphenyl group, and a 3-isopropylphenyl group.

Examples of the an aralkyl group having 7 to 12 carbon atoms include a benzyl group, a diphenylmethyl group, and a naphthylmethyl group.

When at least one of $R^1$, $R^2$, and $R^3$ is the polymerizable double bond-containing group, curing with, for example, active energy rays is possible. In this case, two curing mechanisms, i.e., the curing with the active energy rays and curing by a condensation reaction of silanol groups and/or hydrolyzable silyl groups, allow the cured product obtained to have a high crosslinking density, and the cured product formed can have higher weather resistance.

The number of polymerizable double bond-containing groups present in the polysiloxane segment (a1) is preferably at least two, more preferably 3 to 200, and still more preferably 3 to 50. Specifically, when the content of the polymerizable double bond-containing groups in the polysiloxane segment (a1) is 3 to 35% by weight, the desired weather resistance can be obtained. The above polymerizable double bond-containing groups is a generic term for groups including a vinyl group, a vinylidene group, and a vinylene group that can undergo a propagation reaction of free radicals. The content of the polymerizable double bond-containing groups means the percent by weight of vinyl groups, vinylidene groups, and vinylene groups in the polysiloxane segment.

The polymerizable double bond-containing group used can be any known functional group having a vinyl group, a vinylidene group, or a vinylene group. In particular, a (meth)acryloyl group represented by $-R^4-O-CO-C=CH_2$ or $-R^4-O-CO-C(CH_3)=CH_2$ has high reactivity during curing with ultraviolet light and provides high compatibility with the vinyl-based polymer segment (a2) described later.

When the polymerizable double bond-containing group is the group represented by general formula (3), the structure $Q_n$ in the formula means that a plurality of vinyl groups may be bonded to the aromatic ring. When two Qs are bonded to the aromatic ring, the following structure

[Chem. 8]

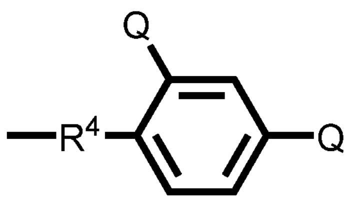

(5)

is also included in general formula (3).

The above structure typified by a styryl group contains no oxygen atom. Therefore, oxidative decomposition starting from an oxygen atom is unlikely to occur, and resistance to thermal decomposition is high, so that the above structure is suitable for applications that require heat resistance. This may be because the bulky structure inhibits the oxidation reaction. To improve heat resistance, it is preferable to include a polymerizable double bond-containing group selected from the group consisting of $-R^4-CH=CH_2$ and $-R^4-C(CH_3)=CH_2$.

(Silanol group and/or hydrolyzable silyl group)

In the present invention, the silanol group is a silicon-containing group having a hydroxy group bonded directly to the silicon atom. Specifically, the silanol group is preferably a silanol group formed by bonding a hydrogen atom to an oxygen atom having a dangling bond and included in the structural unit represented by general formula (1) and/or general formula (2).

In the polysiloxane segment (a1) in the present invention, when at least one of $R^1$, $R^2$, and $R^3$ in the formulas is an epoxy group, thermal curing or active energy ray curing can be used. In this case, two curing mechanisms, i.e., the curing with epoxy groups and the curing by the condensation reaction of silanol groups and/or hydrolyzable silyl groups, allow the cured product obtained to have a high crosslinking density, and a layered body having a lower linear

expansion coefficient can be formed.

In the present invention, the hydrolyzable silyl group is a silicon-containing group having a hydrolyzable group bonded directly to the silicon atom. One specific example of the hydrolyzable silyl group is a group represented by general formula (6).

[Chem. 9]

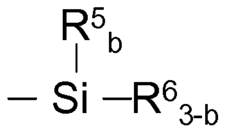

(6)

(In general formula (6), $R^5$ is a monovalent organic group such as an alkyl group, an aryl group, or an aralkyl group, and $R^6$ is a hydrolyzable group selected from the group consisting of halogen atoms, alkoxy groups, acyloxy groups, phenoxy groups, aryloxy groups, mercapto groups, an amino group, amido groups, an aminooxy group, an iminooxy group, and alkenyloxy groups. b is an integer from 0 to 2.)

Examples of the alkyl group for $R^5$ include a methyl group, an ethyl group, a propyl group, an isopropyl group, a butyl group, an isobutyl group, a sec-butyl group, a tert-butyl group, a pentyl group, an isopentyl group, a neopentyl group, a tert-pentyl group, a 1-methylbutyl group, a 2-methylbutyl group, a 1,2-dimethylpropyl group, a 1-ethylpropyl group, a hexyl group, an isohexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1-ethylbutyl group, a 1,1,2-trimethylpropyl group, a 1,2,2-trimethylpropyl group, a 1-ethyl-2-methylpropyl group, and a 1-ethyl-1-methylpropyl group.

Examples of the aryl group include a phenyl group, a naphthyl group, a 2-methylphenyl group, a 3-methylphenyl group, a 4-methylphenyl group, a 4-vinylphenyl group, and a 3-isopropylphenyl group.

Examples of the aralkyl group include a benzyl group, a diphenylmethyl group, and a naphthylmethyl group.

Examples of the halogen atom for $R^6$ include a fluorine atom, a chlorine atom, a bromine atom, and an iodine atom.

Examples of the alkoxy group include a methoxy group, an ethoxy group, a propoxy group, an isopropoxy group, a butoxy group, a sec-butoxy group, and a tert-butoxy group.

Examples of the acyloxy group include formyloxy, acetoxy, propanoyloxy, butanoyloxy, pivaloyloxy, pentanoyloxy, phenylacetoxy, acetoacetoxy, benzoyloxy, and naphthoyloxy.

Examples of the aryloxy group include phenyloxy and naphthyloxy.

Examples of the alkenyloxy group include a vinyloxy group, an allyloxy group, a 1-propenyloxy group, an isopropenyloxy group, a 2-butenyloxy group, a 3-butenyloxy group, a 2-pentenyloxy group, a 3-methyl-3-butenyloxy group, and a 2-hexenyloxy group.

As a result of hydrolysis of the hydrolyzable group represented by $R^6$, the hydrolyzable silyl group represented by general formula (6) becomes a silanol group. In particular, a methoxy group and an ethoxy group are preferred because of their excellent hydrolyzability.

Specifically, the hydrolyzable silyl group is preferably a hydrolyzable silyl group in which an oxygen atom having a dangling bond and included in the structural unit represented by general formula (1) and/or general formula (2) is bonded to or substituted with the above-described hydrolyzable group.

As for silanol groups and hydrolyzable silyl groups, a hydrolytic condensation reaction proceeds among the hydroxy groups in the silanol groups and the hydrolyzable groups in the hydrolyzable silyl groups. In this case, the crosslinking density of the polysiloxane structure increases, and a cured product excellent in weather resistance can be formed.

The silanol group and the hydrolyzable silyl group are used when the polysiloxane segment (a1) and the vinyl-based polymer segment (a2) described later each having these groups are bonded together through the bond represented by general formula (4).

(Additional group)

No particular limitation is imposed on the polysiloxane segment (a1) so long as it has the structural unit represented by general formula (1) and/or general formula (2) and further has a silanol group and/or a hydrolyzable silyl group, and the polysiloxane segment (a1) may contain an additional group. For example, the polysiloxane segment (a1) may be:

a polysiloxane segment (a1) in which a structural unit represented by general formula (1) with $R^1$ being the polymerizable double bond-containing group coexists with a structural unit represented by general formula (1) with $R^1$

being an alkyl group such as a methyl group;

a polysiloxane segment (a1) in which a structural unit represented by general formula (1) with $R^1$ being the polymerizable double bond-containing group coexists with a structural unit represented by general formula (1) with $R^1$ being an alkyl group such as a methyl group and a structural unit represented by general formula (2) with each of $R^2$ and $R^3$ being an alkyl group such as a methyl group; or

a polysiloxane segment (a1) in which a structural unit represented by general formula (1) with $R^1$ being the polymerizable double bond-containing group coexists with a structural unit represented by general formula (2) with each of $R^2$ and $R^3$ being an alkyl group such as a methyl group. There is no particular restriction on the polysiloxane segment (a1).

In the present invention, it is preferable that the polysiloxane segment (a1) is contained in an amount of 1 to 65% by weight with respect to the total weight of solids in the resin composition forming the resin layer (I). In this case, the water absorbability of the resin layer (I) can be reduced, and the condensation reaction of silanol during heating can prevented, so that the adhesion to the third layer (III), the adhesion to the second layer (II), and weather resistance can be achieved simultaneously. More preferably, the polysiloxane segment (a1) is contained in an amount of 1 to 35 wt% with respect to the total weight of solids in the resin composition forming the resin layer (I). In this case, the adhesion to the third layer (III) and also the adhesion to the second layer (II) are strong enough to withstand durability tests such as heat resistance and water resistance tests.

[Composite resin (A) Vinyl-based polymer segment (a2)]

The vinyl-based polymer segment (a2) in the present invention is a polymer segment obtained by polymerization of a vinyl group- or (meth)acrylic group-containing monomer. Examples of the vinyl-based polymer segment (a2) include a vinyl polymer segment, an acrylic polymer segment, and a vinyl/acrylic copolymer segment. Preferably, any of them may be selected according to the intended application. The fine inorganic particle composite in the present invention includes the vinyl-based polymer segment (a2) and is therefore excellent in film forming properties although the fine inorganic particles are contained.

The acrylic polymer segment is obtained, for example, by polymerization or copolymerization of a general-purpose (meth)acrylic monomer. No particular limitation is imposed on the (meth)acrylic monomer, and examples thereof include: alkyl (meth)acrylates each having an alkyl group with 1 to 22 carbon atoms such as methyl (meth)acrylate, ethyl (meth)acrylate, n-propyl (meth)acrylate, n-butyl (meth)acrylate, isobutyl (meth)acrylate, tert-butyl (meth)acrylate, 2-ethylhexyl (meth)acrylate, and lauryl (meth)acrylate; aralkyl (meth)acrylates such as benzyl (meth)acrylate and 2-phenylethyl (meth)acrylate; cycloalkyl (meth)acrylates such as cyclohexyl (meth)acrylate and isobornyl (meth)acrylate; ω-alkoxyalkyl (meth)acrylates such as 2-methoxyethyl (meth)acrylate and 4-methoxybutyl (meth)acrylate; carboxylic acid vinyl esters such as vinyl acetate, vinyl propionate, vinyl pivalate, and vinyl benzoate; alkyl esters of crotonic acid such as methyl crotonate and ethyl crotonate; and dialkyl esters of unsaturated dibasic acids such as dimethyl maleate, di-n-butyl maleate, dimethyl fumarate, and dimethyl itaconate.

In particular, it is preferable to use cyclohexyl (meth)acrylate as the acrylic polymer segment forming the vinyl-based polymer segment (a2), because adhesion to a plastic layer described later, particularly polycarbonate, is improved. In this case, the amount of the cyclohexyl (meth)acrylate in the vinyl-based monomers forming the vinyl-based polymer segment (a2) is preferably 20 to 75% by weight and more preferably 50 to 75% by weight.

Specific examples of the vinyl polymer segment include aromatic vinyl polymer segments, polyolefin polymers, and fluoroolefin polymers, and the vinyl polymer segment may be a copolymer thereof. To obtain such a vinyl polymer, a vinyl group-containing monomer is polymerized. Specific examples of the vinyl group-containing monomer that can be suitably used include: α-olefins such as ethylene, propylene, 1,3-butadiene, and cyclopentyl ethylene; vinyl compounds each having an aromatic ring such as styrene, 1-ethynyl-4-methylbenzene, divinylbenzene, 1-ethynyl-4-methylethylbenzene, benzonitrile, acrylonitrile, p-tert-butylstyrene, 4-vinylbiphenyl, 4-ethynylbenzyl alcohol, 2-ethynylnaphthalene, and phenanthrene-9-ethynyl; and fluoroolefins such as vinylidene fluoride, tetrafluoroethylene, hexafluoropropylene, and chlorotrifluoroethylene. More preferably, the vinyl group-containing monomer is a vinyl compound having an aromatic ring such as styrene or p-tert-butylstyrene.

The vinyl polymer segment may be a vinyl/acrylic copolymer segment obtained by copolymerization of a (meth)acrylic monomer and a vinyl group-containing monomer.

No particular limitation is imposed on the polymerization method, the solvent, and the polymerization initiator for copolymerization of the above monomers, and any know method can be used to obtain the vinyl-based polymer segment (a2). For example, the vinyl-based polymer segment (a2) may be obtained by any of various polymerization methods such as a bulk radical polymerization method, a solution radical polymerization method, and a nonaqueous dispersion radical polymerization method using a polymerization initiator such as 2,2'-azobis(isobutyronitrile), 2,2'-azobis(2,4-dimethylvaleronitrile), 2,2'-azobis(2-methylbutyronitrile), tert-butyl peroxypivalate, tert-butyl peroxybenzoate,

tert-butylperoxy-2-ethylhexanoate, di-tert-butyl peroxide, cumene hydroperoxide, or diisopropyl peroxycarbonate.

The number average molecular weight (hereinafter abbreviated as Mn) of the vinyl-based polymer segment (a2) is preferably within the range of 500 to 200,000. In this case, thickening and gelation when the composite resin (A) is produced can be prevented, and excellent durability is achieved. The Mn is more preferably within the range of 700 to 100,000 and still more preferably within the range of 1,000 to 50,000 because of suitability for application to the third layer (III) described later and adhesion to the third layer (III).

The hydroxyl value (OHv) of the vinyl-based polymer segment (a2) is preferably 65 mgKOH/g or less because excellent water resistance and heat resistance are obtained, and the hydroxyl value is more preferably 45 mgKOH/g or less. Similarly, the hydroxyl value is preferably 65 mgKOH/g or less because the adhesion to a plastic substrate, preferably polycarbonate, after a heat resistance test is high. The hydroxyl value is more preferably 45 mgKOH/g or less.

In the present invention, the hydroxyl value (OHv) of the total solids in the resin composition forming the resin layer (I) is preferably 0 to 50 mgKOH/g. In this case, the water absorbability of the resin layer (I) can be reduced, and a dehydration condensation reaction when the resin layer (I) is heated can be prevented, so that weather resistance and the heat-resistant adhesion and water-resistant adhesion to the third layer (III) and the second layer (II) can be achieved simultaneously. The hydroxyl value of the total solids in the resin composition forming the resin layer (I) is more preferably 0 to 20 mgKOH/g and particularly preferably 0 to 10 mgKOH/g.

The vinyl-based polymer segment (a2) has a silanol group and/or a hydrolyzable silyl group bonded directly to a carbon atom, in order to form the composite resin (A) in which the vinyl-based polymer segment (a2) and the polysiloxane segment (a1) are bonded together through the bond represented by general formula (4). The silanol group and/or the hydrolyzable silyl group forms the bond represented by general formula (4) in the composite resin (A) and rarely remains in the vinyl-based polymer segment (a2) of the final product, i.e., the composite resin (A). However, even when silanol groups and/or hydrolyzable silyl groups remain in the vinyl-based polymer segment (a2), the remaining groups do not cause any problem. In this case, when the fine inorganic particle composite (M) containing the composite resin (A) is cured, a hydrolytic condensation reaction proceeds among the hydroxy groups in the remaining silanol groups and the hydrolyzable groups in the remaining the hydrolyzable silyl groups. Therefore, the crosslinking density of the polysiloxane structure of the cured product obtained increases, and a layered body excellent in heat resistance and abrasion resistance can be formed.

One specific method for introducing a silanol group and/or a hydrolyzable silyl group bonded directly to a carbon atom into the vinyl-based polymer segment (a2) is to use a vinyl-based monomer having a silanol group and/or a hydrolyzable silyl group bonded directly to a carbon atom in combination with the vinyl group-containing monomer and/or the (meth)acrylic monomer when the vinyl-based polymer segment (a2) is polymerized.

Examples of the vinyl-based monomer having a silanol group and/or a hydrolyzable silyl group bonded to a carbon atom include vinyltrimethoxysilane, vinyltriethoxysilane, vinylmethyldimethoxysilane, vinyltri(2-methoxyethoxy)silane, vinyltriacetoxysilane, vinyltrichlorosilane, 2-trimethoxysilylethyl vinyl ether, 3-(meth)acryloyloxypropyltrimethoxysilane, 3-(meth)acryloyloxypropyltriethoxysilane, 3-(meth)acryloyloxypropylmethyldimethoxysilane, and 3-(meth)acryloyloxypropyltrichlorosilane. Of these, vinyltrimethoxysilane, and 3-(meth)acryloyloxypropyltrimethoxysilane are preferred because they allow the hydrolysis reaction to proceed easily and by-products resulting from the reaction can be easily removed.

The vinyl-based polymer segment (a2) in the present invention may have various functional groups. Examples of the functional groups include polymerizable double bond-containing groups, an epoxy group, and alcoholic hydroxy groups. To introduce a functional group, a vinyl-based monomer having the functional group is added during polymerization.

Examples of the vinyl-based monomer having an epoxy group include glycidyl (meth)acrylate, methylglycidyl (meth)acrylate, 3,4-epoxycyclohexylmethyl (meth)acrylate, vinylcyclohexene oxide, glycidylvinyl ether, methylglycidyl vinyl ether, and allyl glycidyl ether.

Examples of the vinyl-based monomer having an alcoholic hydroxy group include hydroxyalkyl esters of various $\alpha,\beta$-ethylenically unsaturated carboxylic acids and their adducts with $\varepsilon$-caprolactone such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 3-chloro-2-hydroxypropyl (meth)acrylate, di-2-hydroxyethyl fumarate, mono-2-hydroxyethyl monobutyl fumarate, polyethylene glycol mono(meth)acrylate, polypropylene glycol mono(meth)acrylate, and "Placcel FM and Placcel FA" [caprolactone-added monomers manufactured by Daicel Chemical Industries, Ltd.].

[Fine inorganic particles (m)]

The fine inorganic particle composite (M) in the present invention is characterized in that the fine inorganic particles (m) are each bonded to the composite resin (A) at the polysiloxane segment (a1) through a siloxane bond.

No particular limitation is imposed on the fine inorganic particles (m) used in the present invention, so long as

the effects of the invention are not impaired. Since the fine inorganic particles (m) are bonded to the polysiloxane segment (a1) through siloxane bonds, the fine inorganic particles (m) each have a functional group capable of forming a siloxane bond.

The functional group capable of forming a siloxane bond may be any functional group capable of forming a siloxane bond such as a hydroxy group, a silanol group, or an alkoxysilyl group. The fine inorganic particles (m) themselves may include a functional group capable of forming a siloxane bond, or the functional group may be introduced by modifying the fine inorganic particles (m).

Any known and commonly used modification method may be used to modify the fine inorganic particles (m). A method including treatment with a silane coupling agent or a method including coating the fine inorganic particles (m) with a resin having a functional group capable of forming a siloxane bond may be used.

Examples of the fine inorganic particles (m) include: particles excellent in heat resistance such as particles of alumina, magnesia, titania, zirconia, silica (quartz, fumed silica, precipitated silica, silicic anhydride, fused silica, crystalline silica, ultrafine amorphous silica; particles excellent in thermal conductivity such as particles of boron nitride, aluminum nitride, alumina, titanium oxide, magnesium oxide, zinc oxide, silicon oxide, etc.; particles excellent in electric conductivity such as metal fillers and metal-coated fillers that use single metals and alloys (e.g., iron, copper, magnesium, aluminum, gold, silver, platinum, zinc, manganese, stainless steel, etc.); particles excellent in barrier properties such as particles of minerals such as mica, clay, kaolin, talc, zeolite, wollastonite, and smectite, and particles of potassium titanate, magnesium sulfate, sepiolite, xonotlite, aluminum borate, calcium carbonate, titanium oxide, barium sulfate, zinc oxide, magnesium hydroxide; particles having a high refractive index such as particles of barium titanate, zirconia, titanium oxide; particles having photocatalytic properties such as particles of photocatalytic metals including titanium, cerium, zinc, copper, aluminum, tin, indium, phosphorus, carbon, sulfur, nickel, iron, cobalt, silver, molybdenum, strontium, chromium, barium, lead, and particles of complexes and oxides of these metals; particles excellent in abrasion resistance such as particles of metals, composites thereof, and oxides thereof including particles of silica, alumina, zirconia, and magnesium; particles excellent in electric conductivity such as particles of metals such as silver and copper, tin oxide, indium oxide, etc.; particles excellent in insulating properties such as particles of silica etc.; and particles excellent in ultraviolet shielding properties such as particles of titanium oxide, zinc oxide.

Appropriate fine inorganic particles (m) may be selected according to the intended application, and one type of particles or a combination of plurality of types may be used. The above fine inorganic particles (m) have various properties in addition to the properties exemplified above, and appropriate fine inorganic particles may be selected according to the intended application.

For example, when the fine inorganic particles (m) used are made of silica, no particular limitation is imposed on the fine inorganic particles (m), and any known fine silica particles such as powdery silica or colloidal silica may be used. Examples of commercial fine powdery silica particles include AEROSIL 50 and 200 manufactured by Nippon Aerosil Co., Ltd., SILDEX H31, H32, H51, H52, H121, and H122 manufactured by Asahi Glass Co., Ltd., E220A and E220 manufactured by Nippon Silica Industries, SYLYSIA 470 manufactured by Fuji Silysia Chemical Ltd., and SG Flake manufactured by Nippon Sheet Glass Co., Ltd.

Examples of commercial colloidal silica include methanol silicasol, IPA-ST, PGM-ST, NBA-ST, XBA-ST, DMAC-ST, ST-UP, ST-OUP, ST-20, ST-40, ST-C, ST-N, ST-O, ST-50, and ST-OL manufactured by Nissan Chemical Industries, Ltd.

Fine silica particles subjected to surface modification may be used. The surface-modified fine silica particles may be, for example, fine silica particles obtained by subjecting any of the above-described fine silica particles to surface treatment with a reactive silane coupling agent having a hydrophobic group or to surface modification with a compound having a (meth)acryloyl group. Examples of commercial powdery silica modified with a compound having a (meth)acryloyl group include AEROSIL RM50, R7200, and R711 manufactured by Nippon Aerosil Co., Ltd. Examples of commercial colloidal silica modified with a compound having a (meth)acryloyl group include MIBK-SD and MEK-SD manufactured by Nissan Chemical Industries, Ltd. Examples of colloidal silica subjected to surface treatment with a reactive silane coupling agent having a hydrophobic group include MIBK-ST and MEK-ST manufactured by Nissan Chemical Industries, Ltd.

No particular limitation is imposed on the shape of the fine silica particles, and the fine silica particles may have a spherical shape, a hollow shape, a porous shape, a rod shape, a plate shape, a fiber shape, or an irregular shape. Examples of usable commercial hollow fine silica particles include Silinax manufactured by Nittetsu Mining Co., Ltd.

Not only an extender but also an ultraviolet responsive photocatalyst can be used as the fine titanium oxide particles, and the fine titanium oxide particles used may be, for example, particles of anatase type titanium oxide, rutile type titanium oxide, or brookite type titanium oxide. Titanium oxide particles designed so as to respond to visible light by doping their crystal structure with a different element may also be used. An anionic element such as nitrogen, sulfur, carbon, fluorine, or phosphorus, or a cationic element such as chromium, iron, cobalt, or manganese can be suitably used as the doping element for the titanium oxide. The form of the fine titanium oxide particles used may be a powder or a sol or slurry prepared by dispersing the particles in an organic solvent or water. Examples of commercial powdery

fine titanium oxide particles include AEROSIL P-25 manufactured by Nippon Aerosil Co., Ltd. and ATM-100 manufactured by Tayca Corporation. Examples of commercial slurry-like fine titanium oxide particles include TKD-701 manufactured by Tayca Corporation.

In the fine inorganic particles (m) in the present invention, its average particle diameter in the composition containing the fine inorganic particle composite (M) is preferably within the range of 5 to 200 nm. When the average particle diameter is 5 nm or more, the fine inorganic particles (m) are well dispersed. When the average particle diameter is 200 nm or less, the strength of the cured product is preferable. The average particle diameter is more preferably 10 nm to 100 nm and still more preferably 10 nm to 80 nm. The "average particle diameter" as used herein is measured using, for example, a particle size distribution measuring device that utilizes a dynamic light scattering method.

In the fine inorganic particle composite (M) in the present invention, the fine inorganic particles (m) may be mixed in an amount of 5 to 90% by weight with respect to the total weight of solids in the fine inorganic particle composite (M), and the amount mixed may be appropriately changed according to the intended application.

For example, to achieve abrasion resistance and interlayer adhesion simultaneously, the amount is preferably 5 to 90% by weight. To further improve the abrasion resistance, the amount is particularly preferably 5 to 60% by weight.

Particles of alumina, magnesia, titania, zirconia, silica, etc. may be additionally mixed as non-bonded fine inorganic particles.

When, for example, silica used as the fine inorganic particles (m) is simply mixed with a resin to obtain the resin layer (I), a problem arises in that the coating is eroded by water entering from silica portions and deteriorates because silica is hydrophilic. However, in the fine inorganic particle composite (M) in the present invention, the fine inorganic particles (m) are firmly bonded to the resin. Therefore, phase separation and separation from the resin are prevented, and excellent water resistance and heat resistance are obtained. The layered body can be preferably used for building materials and automobile-related members that are used outdoors.

[Method for producing fine inorganic particle composite (M)]

The fine inorganic particle composite (M) in the present invention can be obtained by a production method including step 1 of synthesizing the vinyl-based polymer segment (a2) having a silanol group and/or a hydrolyzable silyl group bonded directly to a carbon atom, step 2 of mixing alkoxysilane and the fine inorganic particles (m), and step 3 of subjecting the alkoxysilane to a condensation reaction. In this case, the above steps may be performed separately or simultaneously. For example, the following methods may be used for the production.

<Method 1> In this method, the vinyl-based polymer segment (a2) obtained in step 1 and having a silanol group and/or a hydrolyzable silyl group bonded directly to a carbon atom, a silane compound having a silanol group and/or a hydrolyzable silyl group, and the fine inorganic particles (m) are mixed simultaneously in step 2. In step 3, the silane compound having a silanol group and/or a hydrolyzable silyl group and contained in the mixture is subjected to condensation to form the polysiloxane segment (a1) and form bonds to the vinyl-based polymer segment (a2) and to the fine inorganic particles (m).

<Method 2> The silane compound having a silanol group and/or a hydrolyzable silyl group and the fine inorganic particles (m) are mixed in step 2. In step 3, the silane compound having a silanol group and/or a hydrolyzable silyl group is subjected to condensation to form the polysiloxane segment (a1) and form bonds to the fine inorganic particles. Then the vinyl-based polymer segment (a2) obtained in step 1 and having a silanol group and/or a hydrolyzable silyl group, the polysiloxane segment (a1), and the fine inorganic particles (m) are again subjected to hydrolytic condensation in step 3 to form bonds.

Next, steps 1, 2, and 3 will be described specifically.

Step 1 is a step of synthesizing the vinyl-based polymer segment (a2) having a silanol group and/or a hydrolyzable silyl group bonded directly to a carbon atom. Specifically, the silanol group and/or the hydrolyzable silyl group bonded directly to a carbon atom may be introduced into the vinyl-based polymer segment (a2) in the following manner. When the vinyl-based polymer segment (a2) is polymerized, a vinyl-based monomer having a silanol group and/or a hydrolyzable silyl group bonded directly to a carbon atom is used in combination with the vinyl group-containing monomer and/or the (meth)acrylic monomer.

Thereafter, the vinyl-based polymer segment (a2) and the silane compound having a silanol group and/or a hydrolyzable silyl group may be subjected to hydrolytic condensation to thereby bond a polysiloxane segment precursor to the silanol group and/or the hydrolyzable silyl group bonded directly to the carbon atom.

Step 2 is a step of mixing the silane compound having a silanol group and/or a hydrolyzable silyl group with the fine inorganic particles (m). The silane compound used may be a general-purpose silane compound having a silanol group and/or a hydrolyzable silyl group described later. In this case, when there is a group to be introduced into the polysiloxane segment, a silane compound having the group to be introduced is used in combination with the above silane compound. When, for example, an aryl group is introduced, a silane compound having the aryl group and also having a silanol group and/or a hydrolyzable silyl group may be appropriately used. When a polymerizable double bond-containing group is introduced, a silane compound having the polymerizable double bond-containing group and also having a silanol group and/or a hydrolyzable silyl group may be used.

Any known dispersion method may be used for mixing. Example of mechanical means include a disper, a dispersing apparatus having a stirring blade such as a turbine blade, a paint shaker, a roll mill, a ball mill, an attritor, a sand mill, and a bead mill. To obtain a uniform mixture, it is preferable to perform dispersion by a bead mill using dispersion media such as glass beads or zirconia beads.

Examples of the bead mill include: a Star Mill manufactured by Ashizawa Finetech Ltd.; an MSC-MILL, an SC-MILL, and an Attritor MA01SC manufactured by Mitsui Mining Co., Ltd.; a NANO GRAIN MILL, a PICO GRAIN MILL, a PURE GRAIN MILL, a MECHAGAPER GRAIN MILL, a CERA POWER GRAIN MILL, a DUAL GRAIN MILL, an AD MILL, a TWIN AD MILL, a BASKET MILL, and a TWIN BASKET MILL manufactured by ASADA IRON WORKS Co., Ltd.; and an Apex Mill, an Ultra Apex Mill, and a Super Apex Mill manufactured by Kotobuki Industries Co., Ltd.

Step 3 is a step of subjecting the silane compound having a silanol group and/or a hydrolyzable silyl group to a condensation reaction. In step 3, the silane compound having a silanol group and/or a hydrolyzable silyl group is condensed, and a siloxane bond is formed.

When the silanol group and/or the hydrolyzable silyl group included in the polysiloxane segment (a1) described above and the silanol group and/or the hydrolyzable silyl group included in the vinyl-based polymer segment (a2) described above are subjected to a dehydration condensation reaction, the bond represented by general formula (4) above is formed. Therefore, in general formula (4) above, the carbon atom forms part of the vinyl-based polymer segment (a2), and the silicon atom bonded only to the oxygen atom forms part of the polysiloxane segment (a1).

The silane compound having a silanol group and/or a hydrolyzable silyl group is mixed with the fine inorganic particles (m), and then the mixture is subjected to condensation. Therefore, a siloxane bond is formed between the silane compound having a silanol group and/or a hydrolyzable silyl group and each fine inorganic particle (m), and the polysiloxane segment (a1) is thereby chemically bonded to the fine inorganic particles (m).

In the composite resin (A), the polysiloxane segment (a1) may be bonded to the vinyl polymer segment (a2) at any position. For example, the composite resin (A) may be a composite resin having a graft structure in which the polysiloxane segment (a1) is chemically bonded as a side chain to the polymer segment (2) or may be a composite resin having a block structure in which the polymer segment (a2) and the polysiloxane segment (a1) are chemically bonded to each other.

Specific examples of the silane compound having a polymerizable double bond, further having a silanol group and/or a hydrolyzable silyl group, and used in steps 1 to 3 include vinyltrimethoxysilane, vinyltriethoxysilane, vinylmethyldimethoxysilane, vinyltri(2-methoxyethoxy)silane, vinyltriacetoxysilane, vinyltrichlorosilane, 2-trimethoxysilylethyl vinyl ether, 3-(meth)acryloyloxypropyltrimethoxysilane, 3-(meth)acryloyloxypropyltriethoxysilane, 3-(meth)acryloyloxypropylmethyldimethoxysilane, and 3-(meth)acryloyloxypropyltrichlorosilane. Of these, vinyltrimethoxysilane and 3-(meth)acryloyloxypropyltrimethoxysilane are preferred because they allow the hydrolysis reaction to proceed easily and by-products resulting from the reaction can be easily removed.

Examples of the general-purpose silane compound used in steps 1 to 3 above include: various organotrialkoxysilanes such as methyltrimethoxysilane, methyltriethoxysilane, methyltri-n-butoxysilane, ethyltrimethoxysilane, n-propyltrimethoxysilane, iso-butyltrimethoxysilane, cyclohexyltrimethoxysilane, phenyltrimethoxysilane, and phenyltriethoxysilane; various diorganodialkoxysilanes such as dimethyldimethoxysilane, dimethyldiethoxysilane, dimethyldi-n-butoxysilane, diethyldimethoxysilane, diphenyldimethoxysilane, methylcyclohexyldimethoxysilane, and methylphenyldimethoxysilane; and chlorosilanes such as methyltrichlorosilane, ethyltrichlorosilane, phenyltrichlorosilane, vinyltrichlorosilane, dimethyldichlorosilane, diethyldichlorosilane, and diphenyldichlorosilane. Of these, organotrialkoxysilanes and diorganodialkoxysilanes are preferred because they allow the hydrolysis reaction to proceed easily and by-products resulting from the reaction can be easily removed.

A tetrafunctional alkoxysilane compound such as tetramethoxysilane, tetraethoxysilane, tetra n-propoxysilane, or a partial hydrolytic condensate of any of these tetrafunctional alkoxysilane compounds may also be used, so long as the effects of the present invention are not impaired. When any of the tetrafunctional alkoxysilane compounds or the partial hydrolytic condensate thereof is also used, it is preferable that the ratio of the moles of silicon atoms included in the tetrafunctional alkoxysilane compound to the total moles of silicon atoms included in the polysiloxane segment (a1) does not exceed 20% by mole.

The silane compound described above may be used in combination with a metal alkoxide compound containing a metal other than a silicon atom such as boron, titanium, zirconium, or aluminum so long as the effects of the present invention are not impaired. For example, it is preferable that the metal alkoxide compound is used in combination with the silane compound such that the ratio of the moles of the metal atoms included in the metal alkoxide compound to the total moles of silicon atoms included in the polysiloxane segment (a1) does not exceed 25% by mole.

To introduce the group represented by formula (3) into the polysiloxane segment (a1), a silane compound having the group represented by formula (3) may be used. Specific examples of the silane compound having the group represented by formula (3) include p-styryltrimethoxysilane and p-styryltriethoxysilane.

In step 2, part or all of the silane compound having a silanol group and/or a hydrolyzable silyl group and mixed with the fine inorganic particles (m) may be subjected to hydrolytic condensation.

For the purpose of controlling the content of solids and viscosity, a dispersion medium may be used. The dispersion medium may be any liquid medium that does not impair the effects of the present invention, and examples of such a dispersion medium include various organic solvents, water, and liquid organic polymers and monomers.

Examples of the organic solvents include: ketones such as acetone, methyl ethyl ketone (MEK), and methyl isobutyl ketone (MIBK); cyclic ethers such as tetrahydrofuran (THF) and dioxolane; esters such as methyl acetate, ethyl acetate, and butyl acetate; aromatic compounds such as toluene and xylene; and alcohols such as Carbitol, Cellosolve, methanol, isopropanol, butanol, propylene glycol monomethyl ether, and normal propyl alcohol. These may be used alone or in combination.

The hydrolytic condensation reaction in steps 2 and 3 is the following condensation reaction. Some of the hydrolyzable groups undergo hydrolysis under the influence of water etc., and hydroxy groups are thereby formed. Then a condensation reaction between hydroxy groups or between a hydroxy group and a hydrolyzable group proceeds. Any known method may be used to allow the hydrolytic condensation reaction to proceed. It is preferable to use a method including supplying water and a catalyst in the production step to thereby allow the reaction to proceed, because this method is simple.

Examples of the catalyst used include: inorganic acids such as hydrochloric acid, sulfuric acid, and phosphoric acid; organic acids such as p-toluenesulfonic acid, monoisopropyl phosphate, and acetic acid; inorganic bases such as sodium hydroxide and potassium hydroxide; titanates such as tetraisopropyl titanate and tetrabutyl titanate; various compounds each containing a basic nitrogen atom such as 1,8-diazabicyclo[5.4.0]undecene-7 (DBU), 1,5-diazabicyclo[4.3.0]nonene-5 (DBN), 1,4-diazabicyclo[2.2.2]octane (DABCO), tri-n-butylamine, dimethylbenzylamine, monoethanolamine, imidazole, and 1-methylimidazole; various quaternary ammonium salts such as tetramethylammonium salts, tetrabutylammonium salts, and dilauryldimethylammonium salts with chlorides, bromides, carboxylates, and hydroxides serving as counter anions; and tin carboxylates such as dibutyltin diacetate, dibutyltin dioctoate, dibutyltin dilaurate, dibutyltin diacetylacetonate, tin octylate, and tin stearate. One catalyst alone may be used, or a combination or two or more may be used.

No particular limitation is imposed on the amount of the catalyst added. Generally, the amount of the catalyst used is preferably within the range of 0.0001 to 10% by weight, more preferably within the range of 0.0005 to 3% by weight, and particularly preferably within the range of 0.001 to 1% by weight with respect to the total weight of the compounds each having a silanol group or a hydrolyzable silyl group.

The amount of water supplied is preferably 0.05 moles or more, more preferably 0.1 moles or more, and particularly preferably 0.5 moles or more per mole of silanol groups or hydrolyzable silyl groups included in the compounds each having silanol groups or hydrolyzable silyl groups.

The catalyst and water may be supplied at once or supplied one by one, or a mixture of the catalyst and water prepared in advance may be supplied.

The reaction temperature during the hydrolytic condensation reaction in steps 2 and 3 above is suitably within the range of 0°C to 150°C and preferably within the range of 20°C to 100°C. The reaction may proceed at normal pressure, under increased pressure, or under reduced pressure. If necessary, by-products such as alcohol and water that may be generated during the hydrolytic condensation reaction may be removed by, for example, distillation.

In the resin composition forming the resin layer (I) used in the present invention, the composite resin (A) may have an active energy ray-curable group such as the polymerizable double bond described above or may contain an active energy ray-curable compound. In this case, the composite resin (A) can be cured with active energy rays. Examples of the active energy rays include: ultraviolet rays emitted from light sources such as xenon lamps, low-pressure mercury lamps, high pressure mercury lamps, ultrahigh-pressure mercury lamps, metal halide lamps, carbon arc lamps, and tungsten lamps; and electron beams, alpha rays, β rays, and γ rays generally obtained from particle accelerators of 20 to 2,000 kV. Of these, ultraviolet rays and electron beams are preferably used. Ultraviolet rays are particularly preferable. The source of the ultraviolet rays used may be sunlight, a low-pressure mercury lamp, a highpressure mercury lamp, an ultrahigh pressure mercury lamp, a carbon arc lamp, a metal halide lamp, a xenon lamp, an argon laser, or a helium-cadmium laser. One of the above ultraviolet ray sources is used to irradiate a surface coated with the active energy ray curable resin layer with ultraviolet rays with a wavelength of about 180 to about 400 nm, and the coating can thereby be cured. The dose of irradiation with the ultraviolet rays may be appropriately selected according to the type and amount of the photopolymerization initiator used.

Heat may also be applied so long as the layered body is not affected. In this case, the source of the heat may be any known heat source such as hot air or near infrared rays.

When active energy rays are used for curing, it is preferable to use a photopolymerization initiator. The photopolymerization initiator used may be any known photopolymerization initiator. For example, at least one selected from the group consisting of acetophenones, benzil ketals, benzophenones, and benzoins may be preferably used. Examples of the acetophenones include diethoxyacetophenone, 2-hydroxy-2-methyl-1-phenylpropan-1-one, 1-(4-isopropylphenyl)-2-hydroxy-2-methylpropan-1-one, and 4-(2-hydroxyethoxy)phenyl-(2-hydroxy-2-propyl)ketone. Examples of the benzil ketals include 1-hydroxycyclohexylphenylketone and benzil dimethyl ketal. Examples of the benzophenones include benzophenone and o-benzoylbenzoic acid methyl ester. Examples of the benzoins include benzoin, benzoin methyl ether, and benzoin isopropyl ether. One photopolymerization initiator alone may be used, or two or more photopolymerization initiators may be used in combination.

The amount of the photopolymerization initiator used is preferably 1 to 15% by weight and more preferably 2 to 10% by weight with respect to the solids in the resin composition.

When the resin composition forming the resin layer (I) in the present invention is an active energy ray-curable resin composition, it is preferable to use an ultraviolet absorber. The resin layer (I) formed from the curable resin containing the ultraviolet absorber can prevent yellowing of a plastic substrate. Therefore, the adhesion between the plastic substrate and the resin layer (I) is improved, so that the long-term weather resistance is improved.

The ultraviolet absorber used may be any of various commonly used inorganic and organic ultraviolet absorbers. Examples of the ultraviolet absorber include derivatives of compounds each having a hydroxybenzophenone-based, benzotriazole-based, cyanoacrylate-based or triazine-based main skeleton and polymers such as vinyl polymers having the above ultraviolet absorbers in their side chains. Specific examples include 2,4'-dihydroxybenzophenone, 2,2',4,4'-tetrahydroxybenzophenone, 2-hydroxy-4-methoxybenzophenone, 2-hydroxy-4-methoxybenzophenone-5-sulfonic acid, 2-hydroxy-4-n-octoxybenzophenone, 2-hydroxy-4-n-dodecyloxybenzophenone, 2-hydroxy-4-n-benzyloxybenzophenone, 2,2'-dihydroxy-4,4'-dimethoxybenzophenone, 2,2'-dihydroxy-4,4'-diethoxybenzophenone, 2,2'-dihydroxy-4,4'-dipropoxybenzophenone, 2,2'-dihydroxy-4,4'-dibutoxybenzophenone, 2,2'-dihydroxy-4-methoxy-4'-propoxybenzophenone, 2,2'-dihydroxy-4-methoxy-4'-butoxybenzophenone, 2,3,4-trihydroxybenzophenone, 2-(2-hydroxy-5-t-methylphenyl)benzotriazole, 2-(2-hydroxy-5-t-octylphenyl)benzotriazole, 2-(2-hydroxy-3,5-di-t-butylphenyl)benzotriazole, ethyl-2-cyano-3,3-diphenyl acrylate, 2-ethylhexyl-2-cyano-3,3-diphenyl acrylate, 2-(2-hydroxy-4-hexyloxyphenyl)-4,6-diphenyltriazine, a polymer of 4-(2-acryloxyethoxy)-2-hydroxybenzophenone, and a polymer of 2-(2'-hydroxy-5'-methacryloxyethylphenyl)-2H-benzotriazole. Of these, 2,2',4,4'-tetrahydroxybenzophenone is used preferably in terms of volatility. A combination of two or more organic ultraviolet absorbers may be used.

Preferably, an active energy ray-curable monomer, particularly a polyfunctional (meth)acrylate, is contained as needed. No particular limitation is imposed on the polyfunctional (meth)acrylate, and any known polyfunctional (meth)acrylate may be used. Examples of the polyfunctional (meth)acrylate include polyfunctional (meth)acrylates having at least two polymerizable double bonds in their molecule such as 1,2-ethanediol diacrylate, 1,2-propanediol diacrylate, 1,4-butanediol diacrylate, 1,6-hexanediol diacrylate, dipropylene glycol diacrylate, neopentyl glycol diacrylate, tripropylene glycol diacrylate, trimethylolpropane diacrylate, trimethylolpropane triacrylate, tris(2-acryloyloxy)isocyanurate, pentaerythritol triacrylate, pentaerythritol tetraacrylate, di(trimethylolpropane)tetraacrylate, di(pentaerythritol)pentaacrylate, and di(pentaerythritol)hexaacrylate. Other examples of the polyfunctional acrylate include urethane acrylate, polyester acrylate, and epoxy acrylate. These may be used alone or in combination of two or more.

For example, when the polyfunctional (meth)acrylate is used in combination with polyisocyanate the polyfunctional (meth)acrylate is preferably an acrylate having a hydroxy group such as pentaerythritol triacrylate or dipentaerythritol pentaacrylate. To further increase the crosslinking density, it is effective to use a (meth)acrylate having a high functionality such as di(pentaerythritol)pentaacrylate or di(pentaerythritol)hexaacrylate.

A monofunctional (meth)acrylate may be used in combination with the polyfunctional (meth)acrylate. Examples of the monofunctional (meth)acrylate include: hydroxy group-containing (meth)acrylates such as hydroxyethyl (meth)acrylate, hydroxypropyl (meth)acrylate, hydroxybutyl (meth)acrylate, caprolactone-modified hydroxy (meth)acrylate (e.g., trade name "PLACCEL" manufactured by Daicel Corporation), mono(meth)acrylate of a polyester diol obtained from phthalic acid and propylene glycol, mono(meth)acrylate of a polyester diol obtained from succinic acid and propylene glycol, polyethylene glycol mono(meth)acrylate, polypropylene glycol mono(meth)acrylate, pentaerythritol tri(meth)acrylate, 2-hydroxy-3-(meth)acryloyloxypropyl (meth)acrylate, and (meth)acrylic acid adducts of various epoxy esters; carboxyl group-containing vinyl monomers such as (meth)acrylic acid, crotonic acid, itaconic acid, maleic acid, and fumaric acid; sulfonic acid group-containing vinyl monomers such as vinylsulfonic acid, styrenesulfonic acid, and sulfoethyl (meth)acrylate; acidic phosphate-based vinyl monomers such as 2-(meth)acryloyloxyethyl acid phosphate, 2-(meth)acryloyloxypropyl acid phosphate, 2-(meth)acryloyloxy-3-chloro-propyl acid phosphate, and 2-methacryloyloxyethylphenyl phosphate; and methylol-group-containing vinyl monomers such as N-methylol (meth)acrylamide. These may be used alone or in combination of two or more.

The amount of the polyfunctional acrylate used is preferably 1 to 85% by weight and more preferably 5 to 80% by weight, with respect to the total weight of solids in the active energy ray-curable resin composition. When the amount of the polyfunctional acrylate used is within the above range, physical properties, such as hardness, of a layer to be obtained can be improved.

When the composite resin (A) has an epoxy group, any known curing agent for epoxy resins can be used. Examples of the curing agent include: phenol novolac resins, cresol novolac resins, aromatic hydrocarbon formaldehyde resin-modified phenolic resins, dicyclopentadiene-phenol adduct resins, phenol aralkyl resins (Xylok resins), naphthol

aralkyl resins, trimethylolmethane resins, tetraphenylolethane resins, naphthol novolac resins, naphthol-phenol co-condensed novolac resins, naphthol-cresol co-condensed novolac resins, biphenyl-modified phenolic resins (polyhydric phenolic compounds each having phenol nuclei connected through a bismethylene group), biphenyl-modified naphthol resins (polyhydric naphthol compounds each having phenol nuclei connected through a bismethylene group), aminotriazine-modified phenol resins (polyhydric phenolic compounds each having phenol nuclei connected through melamine, benzoguanamine, etc.), and alkoxy group-containing aromatic ring-modified novolac resins (polyhydric phenolic compounds each having a phenol nucleus and an alkoxy group-containing aromatic ring connected through formaldehyde); anhydride-based compounds such as phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride, and methylhexahydrophthalic anhydride; amide-based compounds such as dicyandiamide and a polyamide resin synthesized from a linolenic acid dimer and ethylenediamine; and amine-based compounds such as diaminodiphenylmethane, diethylenetriamine, triethylenetetramine, diaminodiphenylsulfone, isophoronediamine, imidazole, a BF3-amine complex, and guanidine derivatives.

If necessary, a curing accelerator may also be appropriately used in addition to the above reactive compounds. Various compounds can be used as the curing accelerator. Examples of the curing accelerator include phosphorus-based compounds, tertiary amines, imidazole, metal salts of organic acids, Lewis acids, and amine complex salts. In particular, 2-ethyl-4-methylimidazole, which is an imidazole compound, triphenylphosphine, which is a phosphorus-based compound, and 1,8-diazabicyclo-[5.4.0]-undecene (DBU), which is a tertiary amine are preferred because excellent curability, heat resistance, electric characteristics, moisture-proof reliability, etc. are obtained.

When active energy ray curing and thermal curing are used in combination, it is preferable to select respective catalysts in consideration of the reaction of polymerizable double bonds in the composition, the reaction temperature of thermosetting groups, the reaction time, etc. A thermosetting resin may be used additionally. Examples of the thermosetting resin include vinyl-based resins, unsaturated polyester resins, polyurethane resins, epoxy resins, epoxy ester resins, acrylic resins, phenolic resins, petroleum resins, ketone resins, silicone resins, and resins prepared by modifying these resins.

In the curable resin in the present invention, an organic solvent may be used in addition to the fine inorganic particle composite (M) for the purpose of controlling viscosity. Examples of the organic solvent include aliphatic and alicyclic hydrocarbons such as n-hexane, n-heptane, n-octane, cyclohexane, and cyclopentane; aromatic hydrocarbons such as toluene, xylene, and ethylbenzene; alcohols such as methanol, ethanol, n-butanol, ethylene glycol monomethyl ether, and propylene glycol monomethyl ether; esters such as ethyl acetate, butyl acetate, n-butyl acetate, n-amyl acetate, ethylene glycol monomethyl ether acetate, and propylene glycol monomethyl ether acetate; ketones such as acetone, methyl ethyl ketone, methyl isobutyl ketone, methyl n-amyl ketone, and cyclohexanone; polyalkylene glycol dialkyl ethers such as diethylene glycol dimethyl ether and diethylene glycol dibutyl ether; ethers such as 1,2-dimethoxyethane, tetrahydrofuran, and dioxane; N-methylpyrrolidone; dimethylformamide; dimethylacetamide; and ethylene carbonate. These may be used alone or in combination of two or more.

If necessary, various additives may be used such as an inorganic pigment, an organic pigment, an extender, a clay mineral, a wax, a surfactant, a stabilizer, a flow modifier, a dye, a leveling agent, a rheology controller, an antifoaming agent, an antioxidant, and a plasticizer.

The leveling agent is a liquid organic polymer that does not contribute directly to the curing reaction, and examples of the leveling agent include modified carboxyl group-containing polymers (FLOWLEN G-900, NC-500: KYOEISHA CHEMICAL Co., Ltd.), an acrylic polymer (FLOWLEN WK-20: KYOEISHA CHEMICAL Co., Ltd.), an amine salt of a specially modified phosphate (HIPLAAD ED-251: Kusumoto Chemicals, Ltd.), and a modified acryl-based block copolymer (DISPER BYK 2000: BYK-Chemie).

By introducing a metal alkoxide or a silane coupling agent having a silanol group into the resin layer (I), the chemical bond between the resin layer (I) and the second layer (II) can be further enhanced, and the adhesion between the resin layer (I) and the second layer (II) can be further improved. The silane coupling agent used may be a silane compound not only having an alkoxide group but also having a reactive group such as a (meth)acryloyl group or an epoxy group or a reactive group other than the metal alkoxide such as an isocyanate group or a mercapto group.

No particular limitation is imposed on the amount of the silane coupling agent used, so long as the effects of the present invention are not influenced. The amount of the silane coupling agent is preferably 1 to 50% by weight when the total weight of solids in the resin composition is set to 100% by weight. In particular, when different types of materials, e.g., an inorganic oxide layer and a plastic layer, are bonded together, the amount of the silane coupling agent is particularly preferably 5 to 20%.

The silane coupling agent is, for example, a silane compound having a silanol group and/or a hydrolyzable silyl group. Specifically, any known and commonly used silane compound may be used, and examples thereof include: various organotrialkoxysilanes such as methyltrimethoxysilane, methyltriethoxysilane, methyltri-n-butoxysilane, ethyltrimethoxysilane, n-propyltrimethoxysilane, iso-butyltrimethoxysilane, cyclohexyltrimethoxysilane, tris-(trimethoxysilylpropyl)isocyanurate, 3-aminopropyltrimethoxysilane, and 3-aminopropyltriethoxysilane; various diorganodialkoxysilanes such as dimethyldimethoxysilane, dimethyldiethoxysilane, dimethyldi-n-butoxysilane, diethyldimethoxysilane, and methylcyclohexyldimethoxysilane; and chlorosilanes such as methyltrichlorosilane, ethyltrichlorosilane, vinyltrichlorosilane, dimethyldichlorosilane, and diethyldichlorosilane. Of these, tris-(trimethoxysilylpropyl)isocyanurate is preferable in terms of hardness and compatibility with organic resins.

A silane compound having a functional group other than a silanol group and/or a hydrolyzable silyl group may be used. Examples of the functional group other than a silanol group and/or a hydrolyzable silyl group include polymerizable double bond-containing groups and an epoxy group.

Examples of the silane compound having a polymerizable double bond-containing group include vinyltrimethoxysilane, vinyltriethoxysilane, vinylmethyldimethoxysilane, vinyltri(2-methoxyethoxy)silane, vinyltriacetoxysilane, vinyltrichlorosilane, 2-trimethoxysilylethyl vinyl ether, 3-(meth)acryloyloxypropyltrimethoxysilane, 3-(meth)acryloyloxypropyltriethoxysilane, 3-(meth)acryloyloxypropylmethyldimethoxysilane, and 3-(meth)acryloyloxypropyltrichlorosilane, and they may be used in combination. Of these, vinyltrimethoxysilane and 3-(meth)acryloyloxypropyltrimethoxysilane are preferred because they facilitate the hydrolysis reaction.

Examples of the epoxy group-containing silane compound include γ-glycidoxypropyltrimethoxysilane, γ-glycidoxypropyltriethoxysilane, γ-glycidoxypropyltrimethoxyethoxysilane, γ-glycidoxypropyltriacetoxysilane, β-(3,4-epoxycyclohexyl)ethyltrimethoxysilane, β-(3,4-epoxycyclohexyl)ethyltriethoxysilane, β-(3,4-epoxycyclohexyl)ethyltrimethoxyethoxysilane, β-(3,4-epoxycyclohexyl)ethyltriacetoxysilane, γ-glycidoxypropyldimethoxymethylsilane, γ-glycidoxypropyldiethoxymethylsilane, γ-glycidoxypropyldimethoxyethoxymethylsilane, γ-glycidoxypropyldiacetoxymethylsilane, β-(3,4-epoxycyclohexyl)ethyldimethoxymethylsilane, β-(3,4-epoxycyclohexyl)ethyldiethoxymethylsilane, β-(3,4-epoxycyclohexyl)ethyldimethoxyethoxymethylsilane, β-(3,4-epoxycyclohexyl)ethyldiacetoxymethylsilane, γ-glycidoxypropyldimethoxyethylsilane, γ-glycidoxypropyldiethoxyethylsilane, γ-glycidoxypropyldimethoxyethoxyethylsilane, γ-glycidoxypropyldiacetoxyethylsilane, β-(3,4-epoxycyclohexyl)ethyldimethoxyethylsilane, β-(3,4-epoxycyclohexyl)ethyldiethoxyethylsilane, β-(3,4-epoxycyclohexyl)ethyldimethoxyethoxyethylsilane, β-(3,4-epoxycyclohexyl)ethyldiacetoxyethylsilane, γ-glycidoxypropyldimethoxyisopropylsilane, γ-glycidoxypropyldiethoxyisopropylsilane, γ-glycidoxypropyldimethoxyethoxyisopropylsilane, γ-glycidoxypropyldiacetoxyisopropylsilane, β-(3,4-epoxycyclohexyl)ethyldiethoxyisopropylsilane, β-(3,4-epoxycyclohexyl)ethyldimethoxyethoxyisopropylsilane, β-(3, 4-epoxycyclohexyl)ethyldiacetoxyisopropylsilane, γ-glycidoxypropylmethoxydimethylsilane, γ-glycidoxypropylethoxydimethylsilane, γ-glycidoxypropylmethoxyethoxydimethylsilane, γ-glycidoxypropylacetoxydimethylsilane, β-(3,4-epoxycyclohexyl)ethylmethoxydimethylsilane, β-(3,4-epoxycyclohexyl)ethylethoxydimethylsilane, β-(3,4-epoxycyclohexyl)ethylmethoxyethoxydimethylsilane, β-(3,4-epoxycyclohexyl)ethylacetoxydimethylsilane, γ-glycidoxypropylmethoxydiethylsilane, γ-glycidoxypropylethoxydiethylsilane, γ-glycidoxypropylmethoxyethoxydiethylsilane, γ-glycidoxypropylacetoxydiethylsilane, β-(3,4-epoxycyclohexyl)ethylmethoxydiethylsilane, β-(3,4-epoxycyclohexyl)ethylethoxydiethylsilane, β-(3,4-epoxycyclohexyl)ethylmethoxyethoxydiethylsilane, β-(3,4-epoxycyclohexyl)ethylacetoxydiethylsilane, γ-glycidoxypropylmethoxydiisopropylsilane, γ-glycidoxypropylethoxydiisopropylsilane, γ-glycidoxypropylmethoxyethoxydiisopropylsilane, γ-glycidoxypropylacetoxydiisopropylsilane, β-(3,4-epoxycyclohexyl)ethylmethoxydiisopropylsilane, β-(3,4-epoxycyclohexyl)ethylethoxydiisopropylsilane, β-(3,4-epoxycyclohexyl)ethylmethoxyethoxydiisopropylsilane, β-(3, 4-epoxycyclohexyl)ethylacetoxydiisopropylsilane, γ-glycidoxypropylmethoxyethoxymethylsilane, γ-glycidoxypropylacetoxymethoxymethylsilane, γ-glycidoxypropylacetoxyethoxymethylsilane, β-(3,4-epoxycyclohexyl)ethylmethoxyethoxymethylsilane, β-(3,4-epoxycyclohexyl)ethylmethoxyacetoxymethylsilane, β-(3,4-epoxycyclohexyl)ethylethoxyacetoxymethylsilane, γ-glycidoxypropylmethoxyethoxyethylsilane, γ-glycidoxypropylacetoxymethoxyethylsilane, γ-glycidoxypropylacetoxyethoxyethylsilane, β-(3,4-epoxycyclohexyl)ethylmethoxyethoxyethylsilane, β-(3,4-epoxycyclohexyl)ethylmethoxyacetoxyethylsilane, β-(3,4-epoxycyclohexyl)ethylethoxyacetoxyethylsilane, γ-glycidoxypropylmethoxyethoxyisopropylsilane, γ-glycidoxypropylacetoxymethoxyisopropylsilane, γ-glycidoxypropylacetoxyethoxyisopropylsilane, β-(3,4-epoxycyclohexyl)ethylmethoxyethoxyisopropylsilane, β-(3,4-epoxycyclohexyl)ethylmethoxyacetoxyisopropylsilane, β-(3,4-epoxycyclohexyl)ethylethoxyacetoxyisopropylsilane, glycidoxymethyltrimethoxysilane, glycidoxymethyltriethoxysilane, α-glycidoxyethyltrimethoxysilane, α-glycidoxymethyltrimethoxysilane, β-glycidoxyethyltrimethoxysilane, β-glycidoxymethyltrimethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltrimethoxysilane, β-glycidoxybutyltriethoxysilane, γ-glycidoxybutyltrimethoxysilane, γ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylmethyldiethoxysilane, α-glycidoxypropylmethyldimethoxysilane, α-glycidoxypropylmethyldiethoxysilane, β-glycidoxypropylmethyldimethoxysilane, β-glycidoxypropylmethyldiethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldimethoxyethoxysilane, γ-glycidoxypropylmethyldiphenoxysilane, γ-glycidoxypropylethyldimethoxysilane, γ-glycidoxypropylethyldiethoxysilane, γ-glycidoxypropylethyldipropoxysilane, γ-glycidoxypropylvinyldimethoxysilane, and γ-glycidoxypropylvinyldiethoxysilane.

Examples of the silane compound having an isocyanate group or a mercapto group include 3-isocyanatopropyltriethoxysilane, 3-mercaptopropylmethyldimethoxysilane, and 3-mercaptopropyltrimethoxysilane.

(Second layer (II))

The second layer (II) in the present invention is a layer stacked on the resin layer (I). No particular limitation is imposed on the material of the second layer (II), and no particular limitation is imposed on the method for stacking the second layer (II). These may be appropriately selected according to the intended application of the layered body.

Examples of the material of the second layer (II) include quartz, sapphire, glass, optical films, ceramic materials, inorganic oxides, vapor deposited films (CVD, PVD, sputtering), magnetic films, reflective films, metals such as Ni, Cu, Cr, Fe, and stainless steel, paper, SOG (Spin On Glass), SOC (Spin On Carbon), layers of plastics such as polyesters, polycarbonates, and polyimides, TFT array substrates, electrode plates of PDPs, conductive substrates such as ITO and metal substrates, insulating substrates, and silicon-based substrates such as silicon, silicon nitride, polysilicon, silicon oxide, and amorphous silicon substrates. A single top layer or a top layer having a multilayer structure formed by stacking a plurality of materials may be provided. The second layer (II) may include a top layer made of a different material and formed on part of the resin layer (I).

(Third layer (III))

The layered body of the present invention may include, in addition to the second layer (II), the third layer (III). In this case, the third layer (III) may be stacked on a separate substrate. The third layer (III) is stacked on the resin layer (I) so as to be in contact with a surface of the resin layer (I) that is opposite to the second layer (II).

No particular limitation is imposed on the material of the third layer (III), and examples of the material include quartz, sapphire, glass, optical films, ceramic materials, inorganic oxides, vapor deposited films (CVD, PVD, sputtering), magnetic films, reflective films, metals such as Ni, Cu, Cr, Fe, and stainless steel, paper, SOG (Spin On Glass), SOC (Spin On Carbon), layers of plastics such as polyesters, polycarbonates, and polyimides, TFT array substrates, electrode plates of PDPs, conductive substrates such as ITO and metal substrates, insulating substrates, and silicon-based substrates such as silicon, silicon nitride, polysilicon, silicon oxide, and amorphous silicon substrates. The third layer (III) may be a single layer or may have a multilayer structure formed by stacking a plurality of materials. Part of the surface of the third layer (III) may be made of a different material, and the third layer (III) may include a metal and a plastic joined together.

The second layer (II) and the third layer (III) may have any shape. The second and third layers (II) and (III) may have a flat shape such as a plate shape or a film shape, may be spherical, may have a curved surface, or may have irregularities, so long as the second and third layers (II) and (III) are in contact with the resin layer (I). The second and third layers (II) and (III) may be formed of a composite material including different materials. For example, a complicatedly shaped member including a metallic door and a plastic-made window fitted in the door may be used as the second layer (II) or the third layer (III).

The resin layer (I) in the present invention is characterized by including the resin composition containing the fine inorganic particle composite (M). One feature of the fine inorganic particle composite (M) is that it has good adhesion to both organic and inorganic layers because the polysiloxane segment (a1) and the vinyl-based polymer segment (a2) are contained. Therefore, the resin layer (I) can be used as a good primer for an inorganic oxide layer that is not easily bonded with ordinary resins. When the stacking surface of the second layer (II) is an inorganic oxide layer, the effects of the present invention are more significant.

In particular, in the case where the stacking surface of the second layer (II) is an inorganic oxide layer, the present invention is most effective when the stacking surface of the third layer (III) is a plastic layer. This is because the fine inorganic particle composite (M) contained in the resin layer (I) in the present invention includes the polysiloxane segment (a1) and the vinyl-based polymer segment (a2) and can therefore adhere to both the inorganic oxide layer and the plastic layer. The resin layer (I) in the present invention is particularly excellent as an interlayer material for joining different materials that are generally not easily formed into a layered body.

The resin layer (I) in the present invention contains the fine inorganic particle composite (M). The fine inorganic particle composite (M) includes the polysiloxane segment (a1) and the vinyl-based polymer segment (a2) and therefore has good adhesion to both organic and inorganic layers. Since the adhesion is high, the resin layer (I) can be used as an adhesive and a primer.

(Inorganic oxide layer)

When the stacking surface of the second layer (II) in the present invention is an inorganic oxide layer, the inorganic oxide layer may be formed of silicon oxide, aluminum oxide, titanium oxide, zirconium oxide, zinc oxide, etc. One oxide may be used, or a plurality of oxides may be used simultaneously. Such an inorganic oxide may be deposited on the resin layer (I) by coating or plating or may be in the form of a plate or a sheet. A layer formed by coating the surface of a different material such as a plastic or a metal with the inorganic oxide may be used as the second layer (II).

When the inorganic oxide layer is used as the second layer (II), the second layer (II) can be preferably used as a hard coating film because the hardness of the inorganic oxide layer is very high. In particular, the inorganic oxide layer can be used to protect plastic, rubber, etc. that are easily scratched. Since the refractive index of the inorganic oxide layer can be easily controlled, an optical function such as an antireflection function can be imparted.

When the inorganic oxide layer is used as the third layer (III), the inorganic oxide layer can be used as a substrate for an electronic material. The inorganic oxide layer is excellent in gas barrier properties and can therefore be used for packaging materials, fuel cell members, organic thin film solar cell members, etc.

When the inorganic oxide layer is formed by a coating method, the inorganic oxide layer can be formed by applying and curing a coating solution of the inorganic oxide. For example, the inorganic oxide coating solution may be applied to the resin layer (I), or a coating of the inorganic oxide formed on the surface of a different material such as plastic, metal, glass, etc. may be used as the second layer (II). No particular limitation is imposed on the coating method, and examples of the coating method include a spraying method, a spin coating method, a dipping method, a roll coating method, a blade coating method, a doctor roll method, a doctor blade method, a curtain coating method, a slit coating method, a screen printing method, and an inkjet method.

The material of the inorganic oxide coating solution may be particles of the inorganic oxide or may be a metal alkoxide compound that forms the inorganic oxide through hydrolysis or its hydrolytic condensate. When a metal alkoxide compound is used, it is particularly preferable that the coating solution contains a curable organopolysiloxane that is thermally cured or cured with active energy rays such as an electron beam or ultraviolet light. The curable organopolysiloxane is three-dimensionally crosslinked, and high crosslinking density is obtained. Therefore, the cured organopolysiloxane layer obtained is an inorganic oxide layer with high abrasion resistance.

The metal alkoxide compound or its hydrolytic condensate may be a silane compound having a silanol group and/or a hydrolyzable silyl group or may be their hydrolytic condensate. Specifically, any known and commonly used silane compound may be used, and examples thereof include: various organotrialkoxysilanes such as methyltrimethoxysilane, methyltriethoxysilane, methyltri-n-butoxysilane, ethyltrimethoxysilane, n-propyltrimethoxysilane, iso-butyltrimethoxysilane, and cyclohexyltrimethoxysilane; various diorganodialkoxysilanes such as dimethyldimethoxysilane, dimethyldiethoxysilane, dimethyldi-n-butoxysilane, diethyldimethoxysilane, and methylcyclohexyldimethoxysilane; and chlorosilanes such as methyltrichlorosilane, ethyltrichlorosilane, vinyltrichlorosilane, dimethyldichlorosilane, and diethyldichlorosilane. Of these, organotrialkoxysilanes and diorganodialkoxysilanes are preferred because they allow the hydrolysis reaction to proceed easily and by-products resulting from the reaction can be easily removed.

A silane compound having a functional group other than a silanol group and/or a hydrolyzable silyl group may be used. Examples of the functional group other than a silanol group and/or a hydrolyzable silyl group include polymerizable double bond-containing groups and an epoxy group.

Examples of the silane compound having a polymerizable double bond-containing group and used in combination with the known and commonly used silane compound include vinyltrimethoxysilane, vinyltriethoxysilane, vinylmethyldimethoxysilane, vinyltri(2-methoxyethoxy)silane, vinyltriacetoxysilane, vinyltrichlorosilane, 2-trimethoxysilylethyl vinyl ether, 3-(meth)acryloyloxypropyltrimethoxysilane, 3-(meth)acryloyloxypropyltriethoxysilane, 3-(meth)acryloyloxypropylmethyldimethoxysilane, and 3-(meth)acryloyloxypropyltrichlorosilane. Of these, vinyltrimethoxysilane and 3-(meth)acryloyloxypropyltrimethoxysilane are preferred because they allow the hydrolysis reaction to proceed easily and by-products resulting from the reaction can be easily removed.

Examples of the epoxy group-containing silane compound include γ-glycidoxypropyltrimethoxysilane, γ-glycidoxypropyltriethoxysilane, γ-glycidoxypropyltrimethoxyethoxysilane, γ-glycidoxypropyltriacetoxysilane, β-(3,4-epoxycyclohexyl)ethyltrimethoxysilane, β-(3,4-epoxycyclohexyl)ethyltriethoxysilane, β-(3,4-epoxycyclohexyl)ethyltrimethoxyethoxysilane, β-(3,4-epoxycyclohexyl)ethyltriacetoxysilane, γ-glycidoxypropyldimethoxymethylsilane, γ-glycidoxypropyldiethoxymethylsilane, γ-glycidoxypropyldimethoxyethoxymethylsilane, γ-glycidoxypropyldiacetoxymethylsilane, β-(3,4-epoxycyclohexyl)ethyldimethoxymethylsilane, β-(3,4-epoxycyclohexyl)ethyldiethoxymethylsilane, β-(3,4-epoxycyclohexyl)ethyldimethoxyethoxymethylsilane, β-(3,4-epoxycyclohexyl)ethyldiacetoxymethylsilane, γ-glycidoxypropyldimethoxyethylsilane, γ-glycidoxypropyldiethoxyethylsilane, γ-glycidoxypropyldimethoxyethoxyethylsilane, γ-glycidoxypropyldiacetoxyethylsilane, β-(3,4-epoxycyclohexyl)ethyldimethoxyethylsilane, β-(3,4-epoxycyclohexyl)ethyldiethoxyethylsilane, β-(3,4-epoxycyclohexyl)ethyldimethoxyethoxyethylsilane, β-(3,4-epoxycyclohexyl)ethyldiacetoxyethylsilane, γ-glycidoxypropyldimethoxyisopropylsilane, γ-glycidoxypropyldiethoxyisopropylsilane, γ-glycidoxypropyldimethoxyethoxyisopropylsilane, γ-glycidoxypropyldiacetoxyisopropylsilane, β-(3,4-epoxycyclohexyl)ethyldiethoxyisopropylsilane, β-(3,4-epoxycyclohexyl)ethyldimethoxyethoxyisopropylsilane, β-(3, 4-epoxycyclohexyl)ethyldiacetoxyisopropylsilane, γ-glycidoxypropylmethoxydimethylsilane, γ-glycidoxypropylethoxydimethylsilane, γ-glycidoxypropylmethoxyethoxydimethylsilane, γ-glycidoxypropylacetoxydimethylsilane, β-(3,4-epoxycyclohexyl)ethylmethoxydimethylsilane, β-(3,4-epoxycyclohexyl)ethylethoxydimethylsilane, β-(3,4-epoxycyclohexyl)ethylmethoxyethoxydimethylsilane, β-(3,4-epoxycyclohexyl)ethylacetoxydimethylsilane, γ-glycidoxypropylmethoxydiethylsilane, γ-glycidoxypropylethoxydiethylsilane, γ-glycidoxypropylmethoxyethoxydiethylsilane, γ-glycidoxypropylacetoxydiethylsilane, β-(3,4-epoxycyclohexyl)ethylmethoxydiethylsilane, β-(3,4-epoxycyclohexyl)ethylethoxydiethylsilane, β-(3,4-epoxycyclohexyl)ethylmethoxyethoxydiethylsilane, β-(3,4-epoxycyclohexyl)ethylacetoxydiethylsilane, γ-glycidoxypropylmethoxydiisopropylsilane, γ-glycidoxypropylethoxydiisopropylsilane, γ-glycidoxypropylmethoxyethoxydiisopropylsilane, γ-glycidoxypropylacetoxydiisopropylsilane, β-(3,4-epoxycyclohexyl)ethylmethoxydiisopropylsilane, β-(3,4-epoxycyclohexyl)ethylethoxydiisopropylsilane, β-(3,4-epoxycyclohexyl)ethylmethoxyethoxydiisopropylsilane, β-(3, 4-epoxycyclohexyl)ethylacetoxydiisopropylsilane, γ-glycidoxypropylmethoxyethoxymethylsilane, γ-glycidoxypropylacetoxymethoxymethylsilane, γ-glycidoxypropylacetoxyethoxymethylsilane, β-(3,4-epoxycyclohexyl)ethylmethoxyethoxymethylsilane, β-(3,4-epoxycyclohexyl)ethylmethoxyacetoxymethylsilane, β-(3,4-epoxycyclohexyl)ethylethoxyacetoxymethylsilane, γ-glycidoxypropylmethoxyethoxyethylsilane, γ-glycidoxypropylacetoxymethoxyethylsilane, γ-glycidoxypropylacetoxyethoxyethylsilane, β-(3,4-epoxycyclohexyl)ethylmethoxyethoxyethylsilane, β-(3,4-epoxycyclohexyl)ethylmethoxyacetoxyethylsilane, β-(3,4-epoxycyclohexyl)ethylethoxyacetoxyethylsilane, γ-glycidoxypropylmethoxyethoxyisopropylsilane, γ-glycidoxypropylacetoxymethoxyisopropylsilane, γ-glycidoxypropylacetoxyethoxyisopropylsilane, β-(3,4-epoxycyclohexyl)ethylmethoxyethoxyisopropylsilane, β-(3,4-epoxycyclohexyl)ethylmethoxyacetoxyisopropylsilane, β-(3,4-epoxycyclohexyl)ethylethoxyacetoxyisopropylsilane, glycidoxymethyltrimethoxysilane, glycidoxymethyltriethoxysilane, α-glycidoxyethyltrimethoxysilane, α-glycidoxymethyltrimethoxysilane, β-glycidoxyethyltrimethoxysilane, β-glycidoxymethyltrimethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltrimethoxysilane, β-glycidoxybutyltriethoxysilane, γ-glycidoxybutyltrimethoxysilane, γ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylmethyldiethoxysilane, α-glycidoxypropylmethyldimethoxysilane, α-glycidoxypropylmethyldiethoxysilane, β-glycidoxypropylmethyldimethoxysilane, β-glycidoxypropylmethyldiethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldimethoxyethoxysilane, γ-glycidoxypropylmethyldiphenoxysilane, γ-glycidoxypropylethyldimethoxysilane, γ-glycidoxypropylethyldiethoxysilane, γ-glycidoxypropylethyldipropoxysilane, γ-glycidoxypropylvinyldimethoxysilane, and γ-glycidoxypropylvinyldiethoxysilane.

The inorganic oxide layer may be formed by a plating method. Examples of the plating method include a dry plating method and a wet plating method. Examples of the dry plating method include physical vapor deposition (PVD) methods such as vacuum vapor deposition, sputtering, and ion plating and chemical vapor deposition (CVD) methods, and electroless plating is used as the wet plating method. The dry plating methods are preferred, and chemical vapor deposition (CVD) methods are particularly preferable. With a chemical vapor deposition method (particularly, a plasma chemical vapor deposition method (plasma CVD method)), the inorganic oxide layer obtained can be highly dense and have high abrasion resistance.

When a plating method is used to form the inorganic oxide layer, the resin layer (I) may be used as a primer, and the plating method may be performed directly. The resin layer (I) in the present invention contains the polysiloxane segment (a1) and is therefore highly compatible with inorganic oxide, so that the inorganic oxide layer obtained can be dense and have high adhesion.

An inorganic oxide layer formed by plating the surface of a different material such as metal or quartz may be used as the third layer (III) or the second layer (II). In this case, the resin layer (I) in uncured or semi-cured form is bonded to the inorganic oxide layer, and then the resin layer (I) is cured.

Examples of a hard material that can be used as a plasma CVD coating layer include inorganic vapor deposition layers of $SiO_2$, SiC, TiC, TiN, $TiO_2$, ZnO, $Fe_2O_3$, $V_2O_5$, $SnO_2$, PbO, and $Sb_2O_3$. To obtain a transparent layered body, SiC, $SiO_2$, and ZnO are preferred, and a silicon oxide ($SiO_2$) layer is particularly preferable.

Examples of a silicon compound used as the raw material of the silicon oxide layer obtained by the plasma CVD method include silane, tetramethoxysilane, tetraethoxysilane (TEOS), tetra n-propoxysilane, tetraisopropoxysilane, tetra n-butoxysilane, tetra t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane (HMDSO), bis(dimethylamino)dimethylsilane, bis(dimethylamino)methylvinylsilane, bis(ethylamino)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatosilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiyne, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propyne, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethylcyclotetrasiloxane, and M-silicate 51.

A discharge gas that can easily produce a plasma state is mainly mixed with reactive gases including a raw material gas composed of a silicon compound and a decomposition gas composed of oxygen, and the gas mixture is fed to a plasma discharge generator. The discharge gas used is oxygen gas, nitrogen gas, and/or group 18 elements in the periodic table such as helium, neon, argon, krypton, xenon, and radon. Of these, oxygen, nitrogen, helium, and argon are preferably used.

(Plastic layer)

The fine inorganic particle composite (M) contained in the resin layer (I) in the present invention includes the vinyl-based polymer segment (a2), and the adhesion of the resin layer (I) to plastic layers is high. No particular limitation is imposed on the materials of the plastic layers, so long as they are resins. For example, thermosetting resins and thermoplastic resins can be used.

A thermosetting resin is a resin that has the property of becoming substantially insoluble and infusible after cured by means of heat, radiation, or a catalyst. Specific examples of the thermosetting resin include phenolic resins, urea resins, melamine resins, benzoguanamine resins, alkyd resins, unsaturated polyester resins, vinyl ester resins, diallyl terephthalate resins, epoxy resins, silicone resins, urethane resins, furan resins, ketone resins, xylene resins, and thermosetting polyimide resins. One or a combination of at least two of these thermosetting resins may be used.

A thermoplastic resin is a resin that can be melt-molded under heating. Specific examples of the thermoplastic resin include polyethylene resins, polypropylene resins, polystyrene resins, rubber-modified polystyrene resins, acrylonitrile-butadiene-styrene (ABS) resins, acrylonitrile-styrene (AS) resins, polymethyl methacrylate resins, acrylic resins, polyvinyl chloride resins, polyvinylidene chloride resins, polyethylene terephthalate resins, ethylene vinyl alcohol resins, cellulose acetate resins, ionomer resins, polyacrylonitrile resins, polyamide resins, polyacetal resins, polybutylene terephthalate resins, polylactic acid resins, polyphenylene ether resins, modified polyphenylene ether resins, polycarbonate resins, polysulfone resins, polyphenylene sulfide resins, polyetherimide resins, polyether sulfone resins, polyarylate resins, thermoplastic polyimide resins, polyamide-imide resins, polyether ether ketone resins, polyketone resins, liquid crystal polyester resins, fluororesins, syndiotactic polystyrene resins, and cyclic polyolefin resins. One or a combination of at least two of these thermoplastic resins may be used.

The plastic layer may be a single layer or may have a layered structure including at least two layers. The plastic layer may be a fiber reinforced plastic (FRP).

When the layered body of the present invention is a transparent layered body, it is preferable that the plastic layer is formed of a polycarbonate resin (e.g., an aliphatic polycarbonate, an aromatic polycarbonate, or alicyclic polycarbonate), a polymethyl methacrylate resin, a polystyrene resin, etc.

If necessary, the plastic layer may contain known additives such as an antistatic agent, an antifogging agent, an anti-blocking agent, an ultraviolet absorber, an antioxidant, a pigment, an organic filler, an inorganic filler, a light stabilizer, a nucleating agent, and a lubricant, so long as the effects of the present invention are not impaired.

To further improve the adhesion between the plastic layer and the resin layer (I) in the present invention, the stacking surface of the plastic layer to be stacked on the resin layer (I) may be subjected to known surface treatment. Examples of the surface treatment include corona discharge treatment, plasma treatment, flame plasma treatment, electron beam irradiation treatment, and ultraviolet irradiation treatment. One or a combination of at least two of these treatments may be performed. For the purpose of increasing the adhesion to the resin layer (I), a primer coat, for example, may have been applied.

The plastic layer in the present invention may be formed on the resin layer (I) by direct coating or direct forming, or a plastic layer formed in advance may be stacked. When direct coating is used, no particular limitation is imposed on the coating method, and examples of the coating method include a spraying method, a spin coating method, a dipping method, a roll coating method, a blade coating method, a doctor roll method, a doctor blade method, a curtain coating method, a slit coating method, a screen printing method, and an inkjet method. When direct forming is used, in-mold forming, insert forming, vacuum forming, extrusion lamination forming, press forming, etc. may be performed.

When a plastic layer formed in advance is stacked, the resin layer (I) may be applied to the formed plastic layer and then cured to stack them on one another, or the plastic layer and the resin layer (I) may be bonded together with

one of them being in uncured or semi-cured form and then cured.

(Layered body)

The layered body of the present invention includes the resin layer (I) and the second layer (II) stacked on top of one another or incudes the third layer (III), the resin layer (I), and the second layer (II) stacked on top of one another. Since the resin layer (I) in the present invention has good adhesion to both organic and inorganic layers, the layered body has high durability. Since the resin layer (I) is excellent in abrasion resistance, long-term weather resistance (prevention of yellowing and adhesion), heat-resistant adhesion, and water-resistant adhesion, these functions can be imparted to the layered body.

In the layered body of the present invention, no particular limitation is imposed on the thickness of the resin layer (I). However, in terms of the ability of the resin layer (I) to form the layered body having adhesion and long-term weather resistance, the thickness of the resin layer (I) is preferably 5 to 50 μm. When the thickness is 5 μm or more, the weather resistance and the adhesion are highly effective. When the thickness is 50 μm or less, the resin layer (I) is cured sufficiently, and the durability of the layered body increases. When the second layer (II) is an inorganic oxide layer, its thickness is preferably 1 to 25 μm and particularly preferably 3 to 15 μm in terms of abrasion resistance.

When a layered body is formed by preparing the resin layer (I) and the second layer (II) in this order, the layered body obtained may be in sheet form or may have a three-dimensional structure. The layered body may be in contact with or bonded to the third layer (III) or may cover the third layer (III) without contact to protect the third layer (III).

A layered body integrated with the third layer (III) may be formed as follows. The resin layer (I) may be formed on the third layer (III) and then cured, and then the second layer (II) may be formed. Alternatively, after the resin layer (I) in uncured or semi-cured form is formed on the third layer (III), the second layer (II) is formed, and then the resin layer (I) is completely cured. When the third layer (III) is an active energy ray-curable plastic, the third layer (III) in uncured or semi-curd form and the resin layer (I) in uncured or semi-curd form may be formed, and then the third layer (III) and the resin layer (I) may be completely cured before or after the formation of the second layer (II). In this case, the adhesion between the third layer (III) and the resin layer (I) is further improved.

(Applications)

The layered body of the present application can be particularly preferably usable as various protective materials because the layered body is excellent in hard coating properties, heat resistance, water resistance, weather resistance, and light fastness. The layered body can be used for, for example, building materials, household appliances, transporters such as automobiles, ships, airplanes, and railroads, electronic materials, recording materials, optical materials, lighting fixtures, packaging materials, protection of outdoor installations, coatings for optical fibers, protection of resin glass, etc.

EXAMPLES

Next, the present invention will be described more specifically by way of Examples and Comparative Examples. In the Examples, "part" and "%" are based on weight unless otherwise specified.

In the Examples, the number average molecular weight used is a value measured by GPC (gel permeation chromatography) under the following conditions.

(a) Apparatus: gel permeation chromatograph GCP-244 (manufactured by WATERS)
(b) Columns: Shodex HFIP 80M × 2 (manufactured by Showa Denko K.K.)
(c) Solvent: dimethylformamide
(d) Flow rate: 0.5 mL/min
(e) Temperature: 23°C
(f) Sample concentration: 0.1%, solubility: complete dissolution, filtration: Myshoridisk W-13-5
(g) Injection amount: 0.300 mL
(h) Detector: R-401 differential refractometer (WATERS)
(i) Molecular weight calibration: polystyrene (standard product)

In the Examples, the hydroxyl value (OHv) of a vinyl-based polymer segment was measured according to JIS-K0070. The value obtained is an estimated value for solids in consideration of the vinyl polymer concentration of a resin solution.

Abbreviations for the compounds used in the Examples are shown in the following Tables 1 to 3.

[Table 1]

Table 1

| Abbreviation | Compound |
|---|---|
| AA | Acrylic acid |
| BA | Butyl acrylate |
| MMA | Methyl methacrylate |
| BMA | n-Butyl methacrylate |
| St | Styrene |
| GMA | Glycidyl methacrylate |
| CHMA | Cyclohexyl methacrylate |
| HEMA | 2-Hydroxyethyl methacrylate |
| MPTS | 3-Methacryloxypropyltrimethoxysilane |
| P-stTS | p-Styryltrimethoxysilane |
| VTMS | Vinyltrimethoxysilane |
| MTMS | Methyltrimethoxysilane |
| PTMS | Phenyltrimethoxysilane |
| GPTS | 3-Glycidoxypropyltrimethoxysilane |
| DMDMS | Dimethyldimethoxysilane |

[Table 2]

Table 2

| Abbreviation | Compound |
|---|---|
| MIBK | Methyl isobutyl ketone |
| PGM | Propylene glycol monomethyl ether |
| MEK | Methyl ethyl ketone |
| PGMAC | Propylene glycol monomethyl ether acetate |
| DAA | Diacetone alcohol |
| A9300 | Tris(2-acryloyloxyethyl)isocyanurate (manufactured by Shin Nakamura Chemical Co., Ltd.) |
| PETA | Pentaerythritol acrylate |
| AEROSIL 200 | Powdery silica (manufactured by Nippon Aerosil Co., Ltd.) |
| AEROSIL R7200 | Powdery silica (manufactured by Nippon Aerosil Co., Ltd.) |
| PGM-ST | Colloidal silica (manufactured by Nissan Chemical Industries, Ltd.) solid content: 30% by weigh |

[Table 3]

Table 3

| Abbreviation | Compound |
|---|---|
| A-4 | PhoslexA-4 (manufactured by Sakai Chemical Industry Co., Ltd., n-butyl acid phosphate) |
| TBPEH | tert-butylperoxy-2-ethylhexanoate |
| Irg184 | Photopolymerization initiator Irgacure 184 (manufactured by BASF Japan Ltd.) |
| Irg369 | Photopolymerization initiator Irgacure 369 (manufactured by BASF Japan Ltd.) |
| Irg127 | Photopolymerization initiator Irgacure 127 (manufactured by BASF Japan Ltd.) |
| Irg907 | Photopolymerization initiator Irgacure 907 (manufactured by BASF Japan Ltd.) |
| Ti400 | Hydroxyphenyltriazine-based UV absorber Tinuvin 400 (manufactured by BASF Japan Ltd.) |
| RUVA93 | Reactive UV absorber RUVA-93 (manufactured by Otsuka Chemical Co., Ltd.) |
| Ti384 | Benzotriazole-based UV absorber Tinuvin 384 (manufactured by BASF Japan Ltd.) |
| Ti479 | Hydroxyphenyltriazine-based UV absorber Tinuvin 479 (manufactured by BASF Japan Ltd.) |
| Ti123 | Hindered amine-based light stabilizer Tinuvin 123 (manufactured by BASF Japan Ltd.) |
| Ti144 | Hindered amine-based light stabilizer Tinuvin 144 (manufactured by BASF Japan Ltd.) |
| Ti292 | Hindered amine-based light stabilizer Tinuvin 292 (manufactured by BASF Japan Ltd.) |
| 2E4MZ | 2-Ethyl-4-methylimidazole |
| Perbutyl Z | tert-butyl peroxybenzoate (manufactured by NOF CORPORATION) |

Synthesis of polysiloxane segment precursor

<Synthesis Example 1> Synthesis of polysiloxane segment precursor (a1-1)

A reaction vessel equipped with a stirrer, a thermometer, a dropping funnel, a cooling tube, and a nitrogen gas inlet was charged with 415 parts of MTMS and 756 parts of MPTS, and the mixture was heated to 60°C under stirring while nitrogen gas was introduced. Next, a mixture composed of 0.1 parts of Phoslex A-4 and 121 parts of deionized water was added dropwise over 5 minutes. After completion of the dropwise addition, the temperature inside the reaction vessel was raised to 80°C, and the resulting mixture was stirred for 4 hours to allow a hydrolytic condensation reaction to proceed, whereby a reaction product was obtained.

Methanol and water contained in the reaction product obtained were removed under the conditions of a reduced pressure of 1 to 30 kilopascals (kPa) and 40 to 60°C to thereby obtain 1,000 parts of a polysiloxane segment precursor (a1-1) having a number average molecular weight of 1,000.

<Synthesis Examples 2 and 3> Synthesis of polysiloxane segment precursors (a1-2) and (a1-3)

Polysiloxane segment precursors (a1-2) and (a1-3) were obtained in the same manner as in Synthesis Example 1. In this case, a composition ratio shown in Table 4 below was used for the reaction.

[Table 4]

| Table 4 | | Synthesis Example 1 | Synthesis Example 2 | Synthesis Example 3 |
|---|---|---|---|---|
| Polysiloxane segment precursor | | a1-1 | a1-2 | a1-3 |
| Silane compounds (parts by weight) | MTMS | 415 | 112 | 152 |
| | MPTS | 756 | 127 | 277.2 |
| | PTMS | | 32 | 31.7 |
| | DMDMS | | 134 | 134 |
| Additive (parts by weight) | A-4 | 0.1 | 0.3 | 0.3 |

(continued)

| Table 4 | Synthesis Example 1 | Synthesis Example 2 | Synthesis Example 3 |
|---|---|---|---|
| Deionized water (parts by weight) | 121 | 84.2 | 118.3 |
| Number average molecular weight | 1000 | 1000 | 1000 |

<Synthesis Example 4> [Preparation Example of vinyl-based polymer (a2-1)]

A reaction vessel equipped with a stirrer, a thermometer, a dropping funnel, a cooling tube, and a nitrogen gas inlet was charged with 20.1 parts of PTMS, which is a silane compound, 24.4 parts of DMDMS, which is a silane compound, and 107.7 parts of MIBK serving as a solvent, and the mixture was heated to 95°C under stirring while nitrogen gas was introduced.

Next, a mixture containing 1.5 parts of AA, 1.5 parts of BA, 30.6 parts of MMA, 14.4 parts of BMA, 75 parts of CHMA, 22.5 parts of HEMA, 4.5 parts of MPTS, 6.8 parts of TBPEH, and 15 parts of MIBK was added dropwise to the reaction vessel under stirring at the above temperature over 4 hours while nitrogen gas was introduced, and then the resulting mixture was further stirred at the same temperature for 2 hours to thereby obtain a reaction solution containing a vinyl-based polymer having a number average molecular weight of 5,800 and a hydroxyl value (OHv) of 64.7 mgKOH/g. A mixture composed of 0.06 parts of Phoslex A-4 and 12.8 parts of deionized water was added dropwise to the reaction vessel over 5 minutes, and the resulting mixture was stirred at the same temperature for 5 hours to allow the hydrolytic condensation reaction of the silane compounds to proceed. The reaction product was analyzed by $^{1}H$-NMR, and it was found that almost 100% of trimethoxysilyl groups included in the silane monomers in the reaction vessel were hydrolyzed. Next, the mixture was further stirred at the same temperature for 10 hours to obtain a vinyl-based polymer segment precursor (a2-1) in which the amount of remaining TBPEH was 0.1% or less. The amount of remaining TBPEH was measured by iodimetry.

<Synthesis Example 5 to 11> Synthesis of vinyl-based polymer segment precursors (a2-2) to (a2-8)

Vinyl-based polymer segment precursors (a2-2) to (a2-8) were obtained in the same manner as in Synthesis Example 4. In this case, a composition ratio shown in Table 5 below was used for the reaction.

<Synthesis Example 12> Synthesis of vinyl-based polymer segment precursor (a2-9)

A reaction vessel similar to that used in Synthesis Example 1 was charged with 480 parts of PTMS, which is a silane compound, and the PTMS was heated to 95°C under stirring while nitrogen gas was introduced.

Next, a mixture containing 2.4 parts of AA, 2.4 parts of BA, 160.8 parts of MMA, 60 parts of HEMA, 14.4 parts of MPTS, 48 parts of TBPEH, and 48 parts of PTMS was added dropwise to the reaction vessel under stirring at the above temperature over 4 hours while nitrogen gas was introduced, and then the resulting mixture was further reacted for 10 hours to thereby obtain a vinyl-based polymer segment precursor (a2-9) having a number average molecular weight of 6,700 and a hydroxyl value (OHv) of 107.8 mgKOH/g.

[Table 5]

| Table 5 | | Synthesis Example 4 | Synthesis Example 5 | Synthesis Example 6 | Synthesis Example 7 | Synthesis Example 8 | Synthesis Example 9 | Synthesis Example 10 | Synthesis Example 11 | Synthesis Example 12 |
|---|---|---|---|---|---|---|---|---|---|---|
| Vinyl-based polymer | | a2-1 | a2-2 | a2-3 | a2-4 | a2-5 | a2-6 | a2-7 | a2-8 | a2-9 |
| Vinyl-based monomers (parts by weight) | AA | 1.5 | 1.5 | 1.5 | 1.5 | 1.5 | 1.5 | 2.25 | 0.75 | 2.4 |
| | BA | 1.5 | 1.5 | 1.5 | 1.5 | 1.5 | 1.5 | 2.25 | 0.75 | 2.4 |
| | MMA | 30.6 | 56.1 | 30.6 | 30.6 | 38.1 | 26 | 45.9 | 15.3 | 160.8 |
| | CHMA | 75 | 37.5 | 75 | 75 | 75 | 108 | 112.5 | 37.5 | |
| | HEMA | 22.5 | 30 | 7.5 | 7.5 | | 7.5 | 11.25 | 3.75 | 60 |
| | MPTS | 4.5 | 9 | 4.5 | 4.5 | 4.5 | 4.5 | 6.75 | 2.25 | 14.4 |
| Silane compounds (parts by weight) | PTMS | 20.1 | 20.1 | 20.1 | 20.1 | 20.1 | 20.1 | 5.55 | 16.6 | 480+48 |
| | DMDMS | 24.4 | 24.4 | 24.4 | 24.4 | 24.4 | 24.4 | 6.72 | 20.2 | |
| Additives (parts by weight) | TBPEH | 6.8 | 6.8 | 6.8 | 6.8 | 6.8 | 6.8 | 10.1 | 3.4 | 48 |
| | A-4 | 0.06 | 0.06 | 0.06 | 0.06 | 0.06 | 0.06 | 0.02 | 0.05 | |
| Solvents (parts by weight) | MIIBK (1st) | 107.7 | 107.7 | 107.7 | | 122.7 | 107.7 | 176.55 | 55 | |
| | MIIBK (2nd) | 15 | 15 | 15 | | | 15 | 22.5 | 7.45 | |
| | PGM (1st) | | | | 107.7 | | | | | |
| | PGM (2nd) | | | | 15 | | | | | |
| Deionized water (parts by weight) Number average molecular weight | | 12.8 | 12.8 | 12.8 | 12.8 | 12.8 | 12.8 | 3.5 | 10.29 | |
| | | 5800 | 7200 | 6800 | 7300 | 6800 | 7100 | 6500 | 5900 | 6200 |
| OHv(mgKOH/g) | | 64.7 | 86.2 | 21.6 | 21.6 | 0.0 | 21.6 | 21.6 | 21.6 | 107.8 |
| Amount of CHMA added | | 50% | 25% | 50% | 50% | 50% | 72% | 50% | 50% | 0% |

<Preparation Example 1> [Preparation Example of fine inorganic particle dispersion (a3-1)]

415 Parts of MTMS, 756 parts of MPTS, 1,846 parts of AEROSIL R-7200, 1.0 parts of Phoslex A-4, 134 parts of deionized water, and 1,846 parts of MIBK were mixed and dispersed using an Ultra Apex Mill UAM015 manufactured by Kotobuki Industries Co., Ltd. When the dispersion was prepared, zirconia beads having a diameter of 100 μm and used as media were added to the mill such that 70% of the volume of the mill was filled with the zirconia beads, and the compounds added were subjected to circulation pulverization at a peripheral speed of 10 m/s and a flow rate of 1.5 L per minute. The circulation pulverization was performed for 30 minutes to thereby obtain a fine inorganic particle dispersion (a3-1) in which the fine silica particles were dispersed in the mixture.

<Preparation Examples 2 and 3> Preparation of fine inorganic particle dispersions (a3-2) and (a3-3)

Fine inorganic particle dispersions (a3-2) and (a3-3) were prepared using composition ratios shown in Tale 6 below in the same manner as in Preparation Example 1.

<Preparation Example 4> Preparation of fine inorganic particle dispersion (a3-4)

A fine inorganic particle dispersion (a3-4) was obtained in the same manner as in Preparation Example 1 except that a composition ratio shown in Table 6 was used and the particles were dispersed using ROBOMIX manufactured by PRIMIX Corporation.

<Preparation Examples 5 and 6> Preparation of fine inorganic particle dispersions (a3-5) and (a3-6)

Fine inorganic particle dispersions (a3-5) and (a3-6) were prepared using composition ratios shown in Tale 6 below in the same manner as in Preparation Example 1.

<Preparation Examples 7 and 8> Preparation of fine inorganic particle dispersions (a3-7) and (a3-8)

Fine inorganic particle dispersions (a3-7) and (a3-8) were obtained in the same manner as in Preparation Example 1 except that 50% of the volume of the mill was filled with zirconia bead having a diameter of 30 μm and composition ratios shown in Table 6 below were used for the preparation.

[Table 6]

| Table 6 | | Preparation Example 1 | Preparation Example 2 | Preparation Example 3 | Preparation Example 4 | Preparation Example 5 | Preparation Example 6 | Preparation Example 7 | Preparation Example 8 |
|---|---|---|---|---|---|---|---|---|---|
| Fine inorganic particle dispersion | | a3-1 | a3-2 | a3-3 | a3-4 | a3-5 | a3-6 | a3-7 | a3-8 |
| Silane compounds | MTMS | 415 | 412.3 | 651.5 | 276.8 | 233.8 | 581.3 | 13.3 | |
| | MPTS | 756 | 751.9 | 1188.2 | 504.8 | 426.4 | 1060 | 50 | |
| Fine inorganic particles (parts by weight) | AEROSIL 200 | | | 1450.4 | | | | | |
| | AEROSIL R7200 | 1846 | 1836 | | | 1887.1 | 1563.6 | 166.7 | 1846 |
| | PGM-ST | | | | 4107.9 | | | | |
| Additive (parts by weight) | A-4 | 1 | 0.9 | 0.8 | 0.7 | 0.9 | 0.8 | 0.1 | |
| Deionized water (parts by weight) | | 134 | 163.7 | 258.7 | 109.9 | 92.9 | 230.9 | 8.1 | |
| MIIBK (parts by weight) | | 1846 | 1836 | 1450.4 | | 2358.9 | 1563.6 | | 1846 |
| MEK (parts by weight) | | | | | | | | 166.7 | |

Synthesis of fine inorganic particle composite (M)

<Synthesis Example 13> Fine inorganic particle composite (M-1)

886.3 Parts of the fine inorganic particle dispersion (a3-1) was added to 336.8 parts of the vinyl-based polymer segment precursor (a2-1), and the mixture was stirred for 5 minutes. Then 14.7 parts of deionized water was added to the mixture, and the resulting mixture was stirred at 80°C for 4 hours to allow the hydrolytic condensation reaction of the vinyl-based polymer segment precursor and the silane compounds to proceed. The reaction product obtained was distilled under the conditions of a reduced pressure of 1 to 30 kPa and 40 to 60°C for 2 hours to remove methanol and water generated, and then 159.6 parts of MIBK and 620 parts of DAA were added to thereby obtain 1,908 parts of a solution of the fine inorganic particle composite (M-1) with a silica content of 52% by weight (solid content: 33.0%).

<Synthesis Examples 14 to 22> Fine inorganic particle composites (M-2) to (M-10)

Fine inorganic particle composites (M-2) to (M-10) were obtained using compositions shown in Tables 7 and 8 below for the reaction in the same manner as in Synthesis Example 13.

[Table 7]

| Table 7 | | Synthesis Example 13 | Synthesis Example 14 | Synthesis Example 15 | Synthesis Example 16 | Synthesis Example 17 |
|---|---|---|---|---|---|---|
| Fine inorganic particle composite (M) | | M-1 | M-2 | M-3 | M-4 | M-5 |
| Polysiloxane segment precursor | Type | | | | | |
| | Amount mixed | | | | | |
| Vinyl-based polymer segment precursor | Type | a2-1 | a2-2 | a2-3 | a2-3 | a2-4 |
| | Amount mixed | 336.8 | 336.8 | 336.8 | 336.8 | 336.8 |
| Fine inorganic particle dispersion | Type | a3-1 | a3-1 | a3-2 | a3-3 | a3-4 |
| | Amount mixed | 886.3 | 886.3 | 817.2 | 517.1 | 1217.2 |
| Deionized water (first addition) (parts by weight) | | 14.7 | 14.7 | 31.6 | 31.6 | 31.6 |
| Deionized water (second addition) (parts by weight) | | | | | | |
| PGMAC (parts by weight) | | | | | | |
| MIBK (parts by weight) | | 159.6 | 159.6 | 134.4 | 145.1 | |
| DAA (parts by weight) | | 620 | 620 | 557.1 | 417.9 | |
| Solid content of fine inorganic particle composite (% by weight) | | 33 | 32.9 | 34.2 | 35 | 44.9 |
| Amount of fine inorganic particles mixed (% by weight relative to amount of solids) | | 52 | 52 | 50 | 33 | 50 |

[Table 8]

| Table 8 | | Synthesis Example 18 | Synthesis Example 19 | Synthesis Example 20 | Synthesis Example 21 | Synthesis Example 22 |
|---|---|---|---|---|---|---|
| Fine inorganic particle composite (M) | | M-6 | M-7 | M-8 | M-9 | M-10 |
| Polysiloxane segment precursor | Type | | | | | a1-2 |
| | Amount mixed | | | | | 167.1 |
| Vinyl-based polymer segment precursor | Type | a2-5 | a2-7 | a2-8 | a2-6 | a2-9 |
| | Amount mixed | 336.8 | 450 | 188.3 | 336.8 | 85 |
| Fine inorganic particle dispersion | Type | a3-2 | a3-5 | a3-6 | a3-2 | a3-7 |
| | Amount mixed | 817.2 | 794.9 | 959.3 | 817.2 | 607.3 |
| Deionized water (first addition) (parts by weight) | | 31.6 | 19.2 | 57.6 | 31.6 | 19.4 |
| Deionized water (second addition) (parts by weight) | | | | | | 4.3 |
| PGMAC (parts by weight) | | | | | | 214.3 |
| MIBK (parts by weight) | | 134.4 | 59.4 | 134.4 | 134.4 | |
| DAA (parts by weight) | | 557.1 | 557.1 | 557.1 | 557.1 | |
| Solid content of fine inorganic particle composite (% by weight) | | 35.5 | 35.4 | 34.6 | 35.2 | 70 |
| Amount of fine inorganic particles mixed (% by weight relative to amount of solids) | | 50 | 50 | 50 | 50 | 50 |

<Synthesis Example 23> Comparative fine inorganic particle composite (comparative M-1)

The same apparatus as that used in Synthesis Example 13 was charged with 250 parts of the fine inorganic particle dispersion (a3-1), and the dispersion was stirred at 80°C for 4 hours to allow the hydrolytic condensation reaction of the silica dispersion to proceed. The reaction product obtained was distilled under the conditions of a reduced pressure of 1 to 30 kPa and 40 to 60°C for 2 hours to remove methanol and water generated, and then 32.2 parts of MIBK and 124.6 parts of DAA were added to thereby obtain 383 parts of a solution of a comparative fine inorganic particle composite (comparative M-1) (solid content: 35.0%).

<Synthesis Example 24> Comparative fine inorganic particle dispersion (comparative M-2)

The same apparatus as that used in Synthesis Example 13 was charged with 178.8 parts of the polysiloxane segment (a1-1) and 371.2 parts of the vinyl-based polymer segment precursor (a2-2), and the mixture was stirred for 5 minutes. Then 41.0 parts of deionized water was added, and the resulting mixture was stirred at 80°C for 4 hours to allow the hydrolytic condensation reaction of the reaction product and the polysiloxane to proceed. The reaction product obtained was distilled under the conditions of a reduced pressure of 1 to 300 kPa and 40 to 60°C for 2 hours to remove methanol and water generated. Then 195.0 parts of MIBK was added to obtain 600 parts of a composite resin with a non-volatile content of 45.1%. 270 Parts of R7200 used as fine silica particles and 540 parts of MIBK were added to the composite resin obtained, and the mixture was dispersed using an Ultra Apex Mill UAM015 manufactured by Kotobuki Industries Co., Ltd. When the dispersion was prepared, zirconia beads having a diameter of 100 μm and used as media were added to the mill such that 70% of the volume of the mill was filled with the zirconia beads, and the compounds were subjected to circulation pulverization at a peripheral speed of 10 m/s and a flow rate of 1.5 L per minute. The circulation pulverization was performed for 30 minutes to thereby obtain a comparative fine inorganic particle dispersion

(comparative M-2) in which the fine silica particles were dispersed in the composite resin.

<Synthesis Example 25> Comparative fine inorganic particle dispersion (comparative M-3)

A comparative fine inorganic particle dispersion (comparative M-3) was obtained using a composition shown in Table 9 below in the same manner as in Synthesis Example 24.

<Synthesis Example 26> Comparative fine inorganic particle dispersion (comparative M-4)

The fine inorganic particle dispersion produced in Preparation Example 8 was used without any treatment.

[Table 9]

| Table 9 | | Synthesis Example 23 | Synthesis Example 24 | Synthesis Example 25 | Synthesis Example 26 |
|---|---|---|---|---|---|
| Comparative fine inorganic particle composite | | Comparative M-1 | Comparative M-2 | Comparative M-3 | Comparative M-4 |
| Polysiloxane segment (a1) precursor | Type | | a1-1 | a1-3 | |
| | Amount mixed | | 178.8 | 252.3 | |
| Vinyl-based polymer segment (a2) precursor | Type | | a2-2 | a2-9 | |
| | Amount mixed | | 371.2 | 85 | |
| Fine inorganic particle dispersion | Type | a3-1 | | | a3-8 |
| | Amount mixed | 250 | | | 250 |
| Deionized water (first addition) (parts by weight) | | | 41 | 15.7 | |
| PGMAC (first addition) | | | | 107.1 | |
| MIBK (first addition) | | 32.2 | 195 | | |
| DAA | | 124.6 | | | |
| Fine inorganic particles | AEROSIL R7200 | | 270 | 250 | |
| MIBK (second addition) | | | 540 | 2500 | |
| Solid content of fine inorganic particle composite (% by weight) | | 35 | 38.3 | 16.1 | 100 |
| Amount of fine inorganic particles mixed (% by weight relative to amount of solids) | | 50 | 50 | 50 | 50 |

Reference Experimental Examples 1 and 2: Measurement of organic content in fine inorganic particle composite

The fine inorganic particle composite (M-10) produced in Synthesis Example 22, the comparative fine inorganic particle dispersion (comparative M-3) produced in Synthesis Example 25, and AEROSIL R7200 were diluted with MIBK such that the non-volatile content was about 5% by weight. Each diluted product was subjected to centrifugation at 12,000 rpm for 10 min, and the supernatant was removed. This procedure was repeated three times for washing. The precipitate obtained was dried and then heated in an air atmosphere from room temperature to 700°C at 10°C/minute using TG/DTA6200 manufactured by SII. The reduction in weight after the measurement was measured, and the organic content was computed using the following formula.

Organic adsorption amount = (Reduction in weight of fine inorganic particle composite or fine inorganic particle dispersion by TG/DTA) - (Reduction in weight of AEROSIL R7200 by TG/DTA)

[Table 10]

| Table 10 | Fine inorganic particle composite | Organic content (% by weight) |
|---|---|---|
| Reference Experimental Example 1 | M-10 | 4 |
| Reference Experimental Example 2 | Comparative M-3 | 1 |

As can be seen from the above results, the organic content is larger in the fine inorganic particle composite (M). This suggests that the fine inorganic particles are chemically bonded to the composite resin.

(Preparation Example 9 Preparation of curable resin composition (P-1))

100 Parts of the fine inorganic particle composite (M-1) obtained in Synthesis Example 13, 35 parts of A9300, 2.8 parts of Irg 184, 2.8 parts of Ti400, and 0.7 parts of Ti123 were mixed to obtain a curable resin composition (P-1).

[Method for measuring solid content of resin composition]

1 g of a synthesized fine inorganic particle composite was dropped onto an aluminum petri dish and diluted with 5 g of a solution of toluene/methanol = 70/30 wt% to obtain (A). After the dilution, the (A) was held in a dryer heated to a temperature of 108°C for one hour to evaporate the solvents, and the sum (B) of the weight of solids in the fine inorganic particle composite + the weight of the aluminum petri dish was obtained.
The weight percent (C) of the solids in the fine inorganic particle composite was computed using the following formula.

(C) = 100 × ((B) - weight of aluminum petri dish) / 1.0 g

[Method for measuring polysiloxane content of resin composition]

1 g of a resin composition obtained was diluted with 5 g of acetone in a metal vessel and then dried at a temperature of 108°C for 1 hour to thereby obtain resin solids. Then the difference between the weight of the solids obtained and the total weight of the acrylic resin component in the composite resin, the silica component, the polyfunctional acrylate, the photo-initiator component, and the additive component that were used for preparing the coating was determined to compute the polysiloxane content of the coating.

[Measurement of average particle diameter of fine inorganic particles (m) in resin composition]

A resin composition obtained was subjected to measurement using a particle size distribution measuring device (ELS-Z manufactured by Otsuka Electronics Co., Ltd., cell width: 1 cm, dilution solvent: PGM) by a dynamic light scattering method.

[Amount of polysiloxane in solids in resin composition]

The amount of polysiloxane in the solids in a resin composition is computed as follows.

Formula 1) Amount of polysiloxane in solids in resin composition (% by weight) = (weight of solids in fine inorganic particle composite (M) * ratio (%) of polysiloxane contained in solids in fine inorganic particle composite (M)) / weight of solids in resin composition

Formula 2) Ratio (%) of polysiloxane contained in solids in fine inorganic particle composite (M) = 100 - ratio (% by weight) of components other than polysiloxane contained in solids in fine inorganic particle composite (M)

Formula 3) Ratio (% by weight) of components other than polysiloxane contained in solids in fine inorganic particle composite (M) = (total weight of vinyl-based monomers in vinyl-based polymer segment × (ratio of fine inorganic particles (m) (% by weight in solids) / (weight of fine inorganic particles (m) (solid content))) + ratio of fine inorganic particles (m) (% by weight in solids)

(Preparation Examples 10 to 27)

Similarly, curable resin compositions (P-2) to (P-14) and (comparative P-1) to (comparative P-6) were prepared using compositions listed in Tables 11 to 13.

(Example 1 [Method for producing layered body])

(Deposition of resin layer (I))

The curable resin composition (P-1) obtained in one of the above Preparation Examples was diluted with methyl isobutyl ketone (MIBK) such that the solid content was 45%. Then the diluted curable resin composition was applied to an aromatic polycarbonate sheet (thickness: 2 mm, CARBOGLASS Polish Clear manufactured by Asahi Glass Co., Ltd.) using a bar coater, dried at 80°C for 4 minutes, and irradiated with active energy rays using a mercury lamp with a lamp output of 1 kw under the condition of an integrated intensity of 1,500 mJ/$cm^2$ to cure a resin layer (I).

(Deposition of second layer (II))

A second layer (II) was formed on the resin layer (I) using plasma CVD, a thermosetting silsesquioxane, or an active energy ray-curable silsesquioxane such that the thickness of the film was 5 μm.

(Plasma CVD conditions)

(Pretreatment step) Ar (argon) introduction amount: 50 sccm, specified pressure: 20 Pa, plasma output: 6%, time: 60 seconds

(Deposition step) TMS (trimethylsilane) introduction amount: 20 sccm, oxygen introduction amount: 100 sccm, specified pressure: 25 Pa, plasma output: 6%, time: 2,000 seconds

(Synthesis Example of thermosetting organopolysiloxane)

A 2L-flask equipped with a stirrer, a cooling tube, and a thermometer was charged with 250 g of methyltrimethoxysilane. 250 g of a 0.01N aqueous hydrochloric acid solution was added under stirring to allow hydrolysis to proceed. Then methanol generated was removed under heating at 65 to 75°C, and the siloxane generated by hydrolysis was subjected to condensation polymerization for 2 hours to increase molecular weight. Then methanol was removed by heating. After the siloxane became insoluble in water and cloudy, 200 g of cyclohexanone was added. Then the removal of methanol by evaporation was continued, and the heating was stopped when the internal temperature reached 92°C and the methanol was almost completely removed. The mixture was cooled and allowed to stand. Then the mixture was separated into two layers, i.e., a lower siloxane solution layer and an upper water layer, and the lower layer was collected. The lower layer was diluted with 321 g of isopropyl alcohol and filtrated using filter paper to thereby obtain 635 g of thermosetting organopolysiloxane having a solid concentration of 19.6%. The weight average molecular weight of the thermosetting organopolysiloxane obtained was $3.3\times10^3$.

(Conditions of formation of thermosetting organopolysiloxane film)

The thermosetting organopolysiloxane obtained was applied to the resin layer I to a dry thickness of 2 to 3 μm using a bar coater method and then heated and dried using a circulating hot air dryer set to 120°C for 30 minutes to thereby produce a layered body.

(Method for preparing photosensitive organopolysiloxane)

Starting materials including 286.7 parts by mass (0.90 mol) of methacryloxyoctyltrimethoxysilane, 13.6 parts by mass (0.10 mol) of methyltrimethoxysilane, and 503.1 parts by mass of isopropyl alcohol were mixed in a reaction vessel until uniform. Then 15.3 parts by mass of a 20 mass% aqueous solution of tetramethylammonium hydroxide and 95.5 parts by mass of water (water: total of 6.0 mol) were added, and the resulting mixture was stirred at 25°C for 12 hours. Then toluene was added to the mixture, and the resulting mixture was washed with water and neutralized. Then alcohol, toluene, etc. were removed by evaporation. The reaction product obtained had a volatile content of 0.6% by mass, a refractive index of 1.4749, an SiOH group content of 0.8% by mass, and a weight average molecular weight of 5,700. The results of infrared absorption spectrophotometry and nuclear magnetic resonance analysis showed that hydrolytic condensation proceeded ideally, and this reaction product was confirmed to be a photosensitive organopolysiloxane having the following siloxane unit: [MA8SiO3/2]0.9[MeSiO3/2]0.1[OH]0.11[MA8:methacryloxyoctyl].

(Conditions of formation of photosensitive organopolysiloxane film)

100 Parts by mass of the photosensitive organopolysiloxane obtained and 4 parts by mass of IRGACURE 184 (trade name, manufactured by BASF) used as a photopolymerization initiator were mixed to obtain a clear resin composition.

Next, the resin composition was applied to the resin layer I using a bar coater method such that the thickness of the solids was 2 μm and then cured by irradiation with light from a high pressure mercury lamp for 2 seconds (illuminance: 200 mW/cm$^2$, integrated dose: 2,000 mJ/cm$^2$) to thereby obtain a layered body.

(Example 2) to (Example 16) and (Comparative Example 1) to (Comparative Example 7)

Layered bodies were obtained in the same manner as in Example 1 except that the resin layer (I) and the second layer (II), which was the inorganic oxide layer in Example 1, were changed as shown in Tables 14 to 17.

(Example 17 [Method for producing layered body])

The curable resin composition (P-1) obtained in one of the above Preparation Examples was diluted with methyl isobutyl ketone (MIBK) such that the solid content was 45%. Then the diluted curable resin composition was applied to a polycarbonate substrate (thickness: 2 mm, CARBOGLASS manufactured by Asahi Glass Co., Ltd.) using a bar coater, dried at 80°C for 4 minutes, laminated with a cover glass (thickness: 0.5 mm) used as the second layer (II) such that no

air remained, and then irradiated with active energy rays through the glass using a mercury lamp with a lamp output of 1 kw under the condition of an integrated intensity of 1,500 mJ/cm$^2$ to thereby obtain a layered body including the resin layer (I), the second layer (II), and the third layer (III). (Comparative Example 4)

A layered body was obtained in the same manner as in Example 17 except that the resin layer (I) was changed as shown in Table 18.

<Methods for evaluating layered body>

[Abrasion resistance test]

Each layered body was subjected to a Taber abrasion test. Specifically, the surface of the layered body was rubbed using a method according to ASTM D1044 (abrasion wheels: CS-10F, load: 500 g, number of revolutions: 1,000), and the difference from the haze in the initial state, i.e., a change in haze ΔH (%), was measured. The smaller the difference, the higher the abrasion resistance. The abrasion resistance was evaluated from the ΔH value according to the following criteria.

AA: ΔH = less than 2
A: ΔH = 2 to less than 4
B: ΔH = 4 to less than 10
C: ΔH = 10 or more

[Haze]

The light transmittance of a sample is measured using a haze meter, and the value of ΔH (unit: %) is computed using the following formula.

[Formula 1]

Th = Td / Tt (Td: scattered light transmittance, Tt: total light transmittance)

[Weather resistance test]

A super accelerated weathering test instrument called Super UV Tester (SUV) manufactured by IWASAKI ELECTRIC Co., Ltd. was used to subject a sample to a 12-hour cycle including irradiation for 4 hours (irradiation intensity: 90 mW, black panel temperature: 63° C., humidity: 70%), darkness for 4 hours (black panel temperature: 63° C., humidity: 90%), and dew condensation for 4 hours (black panel temperature: 30°C, humidity: 95%), and this cycle was repeated 100 times. Then the appearance (visual evaluation, a change in haze) and adhesion were evaluated. The visual evaluation of the appearance was performed by comparing the appearance of the sample subjected to the 100-cycle test and the appearance of a non-exposed sample.

The sample was evaluated as follow.

(Cracking) The surface state etc. were unchanged: (A)

Cracking occurred partially but was practically acceptable: (B)
Cracking occurred over the entire surface: (C)

(Yellowing) The surface state etc. were unchanged: (A)

Yellowing occurred partially but was practically acceptable: (B)
Yellowing occurred over the entire surface: (C)

[Heat-resistant adhesion test]

Each of the layered bodies obtained was heated in an electric oven at 110°C for 240 hours and then subjected to an adhesion test according to a JIS K-5400 cross-cut test method. Specifically, 1 mm-wide slits were cut in the layered

body using a cutter to form a lattice pattern with 100 squares. Then cellophane tape was applied so as to cover the entire lattice pattern and then peeled off quickly. The adhesion to the polycarbonate plate was evaluated from the number of squares remaining adhering to the polycarbonate plate according to the following criteria.

AA: 100
A: 95 to 99
B: 60 to 94
C: 59 or less

[Heat-resistant adhesion test II]

Each of the layered bodies obtained was heated in an electric oven at 110°C for 240 hours. Then cellophane tape was applied near an end of the layered body subjected to the test and then peeled off quickly. The adhesion to the polycarbonate plate was evaluated according to the following criteria.

A: No peeling occurred.
C: Peeling occurred.

[Water-resistant adhesion test]

Each of the layered bodies obtained was immersed in warm water at 60°C for 240 hours and subjected to an adhesion test according to the JIS K-5400 cross-cut test method. Specifically, 1 mm-wide slits were cut in the layered body using a cutter to form a lattice pattern with 100 squares. Then cellophane tape was applied so as to cover the entire lattice pattern and then peeled off quickly. The adhesion to the polycarbonate plate was evaluated from the number of squares remaining adhering to the polycarbonate plate according to the following criteria.

AA: 100
A: 95 to 99
B: 60 to 94
C: 59 or less

[Clouding test]

Each of the layered bodies obtained was immersed in warm water at 80°C for 240 hours, and the resulting layered body was left to stand under the conditions of 60°C/90%Rh for 24 hours. The sample was removed and returned to room temperature, and a change in appearance was visually inspected.

AA: No clouding occurred.
A: Clouding occurred slightly.
C: Significant clouding occurred.

[Table 11]

| Table 11 | | Preparation Example 9 | Preparation Example 10 | Preparation Example 11 | Preparation Example 12 | Preparation Example 13 | Preparation Example 14 | Preparation Example 15 |
|---|---|---|---|---|---|---|---|---|
| Active energy ray-curable composition | | P-1 | P-2 | P-3 | P-4 | P-5 | P-6 | P-7 |
| Fine inorganic particle composite (M) | Type | M-1 | M-1 | M-1 | M-2 | M-3 | M-4 | M-5 |
| | Amount mixed | 100.0 | 169.7 | 42.4 | 100.0 | 102.3 | 100.0 | 78.0 |
| Reactive compound | A9300 | 35 | 14 | 56 | 35 | 35 | 35 | 35 |
| Silane coupling agents | KBM503 | 0 | 0 | 0 | 0 | 0 | 0 | 0 |
| | KBM9659 | 0 | 0 | 0 | 0 | 0 | 0 | 0 |
| Additives | Irg184 | 2.8 | 2.8 | 2.8 | 2.8 | 2.8 | 2.8 | 2.8 |
| | Ti400 | 2.8 | 2.8 | 2.8 | 2.8 | 2.8 | 2.8 | 2.8 |
| | Ti123 | 0.7 | 0.7 | 0.7 | 0.7 | 0.7 | 0.7 | 0.7 |
| PSi content (%) | | 11.6 | 19.7 | 4.9 | 11.5 | 13.5 | 18.3 | 13.5 |
| OH value | | 7.1 | 12.1 | 3.0 | 9.5 | 2.5 | 3.3 | 2.5 |
| Average particle diameter (nm) of fine organic particles (m) | | 120 | 120 | 120 | 120 | 120 | 130 | 50 |

[Table 12]

| Table 12 | | Preparation Example 16 | Preparation Example 17 | Preparation Example 18 | Preparation Example 19 | Preparation Example 20 | Preparation Example 21 | Preparation Example 22 |
|---|---|---|---|---|---|---|---|---|
| Active energy ray-curable composition | | P-8 | P-9 | P-10 | P-11 | P-12 | P-13 | P-14 |
| Fine inorganic particle composite (M) | Type | M-6 | M-7 | M-8 | M-9 | M-1 | M-1 | M-8 |
| | Amount mixed | 98.6 | 98.9 | 101.2 | 99.4 | 100 | 100 | 161.9 |
| Reactive compound | A9300 | 35 | 35 | 35 | 35 | 28 | 28 | 14 |
| Silane coupling agents | KBM503 | 0 | 0 | 0 | 0 | 7 | 0 | 0 |
| | KBM9659 | 0 | 0 | 0 | 0 | 0 | 7 | 7 |
| Additives | Irg184 | 2.8 | 2.8 | 2.8 | 2.8 | 2.8 | 2.8 | 2.8 |
| | Ti400 | 2.8 | 2.8 | 2.8 | 2.8 | 2.8 | 2.8 | 2.8 |
| | Ti123 | 0.7 | 0.7 | 0.7 | 0.7 | 0.7 | 0.7 | 0.7 |
| PSi content (%) | | 13.5 | 8.1 | 19.2 | 12.1 | 11.6 | 11.6 | 31.1 |
| OH value | | 0.0 | 3.6 | 1.3 | 2.8 | 7.1 | 7.1 | 2.1 |
| Average particle diameter (nm) of fine organic particles (m) | | 120 | 120 | 120 | 120 | 120 | 120 | 120 |

[Table 13]

| Table 13 | | Preparation Example 23 | Preparation Example 24 | Preparation Example 25 | Preparation Example 26 | Preparation Example 27 |
|---|---|---|---|---|---|---|
| Active energy ray-curable composition | | Comparative P-1 | Comparative P-2 | Comparative P-4 | Comparative P-5 | Comparative P-6 |
| Fine inorganic particle composite (M) | Type | Comparative M-1 | Comparative M-2 | Comparative M-4 | Comparative M-4 | Comparative M-4 |
| | Amount mixed | 100 | 100 | 35 | 35 | 35 |
| Reactive compound | A9300 | 35 | 35 | 38 | 38 | 45 |
| | PETA | 0 | 0 | | | |
| Silane coupling agents | KBM503 | 0 | 0 | 7 | | |
| | KBM9659 | 0 | 0 | | 7 | |
| Additives | Irg184 | 2.8 | 2.8 | 2.8 | 2.8 | 2.8 |
| | Ti400 | 2.8 | 2.8 | 2.8 | 2.8 | 2.8 |
| | Ti123 | 0.7 | 0.7 | 0.7 | 0.7 | 0.7 |
| PSi content (%) | | 25 | 10 | 0 | 0 | 0 |
| OH value | | - | 12.9 | 0 | 0 | 0 |
| Average particle diameter (nm) of fine organic particles (m) | | 120 | 120 | 120 | 120 | 120 |

[Table 14]

| Table 14 | Example 1 | Example 2 | Example 3 | Example 4 | Example 5 | Example 6 |
|---|---|---|---|---|---|---|
| Resin layer (I) | P-1 | P-2 | P-3 | P-4 | P-5 | P-6 |
| Vapor-deposited inorganic oxide layer (II) | Yes | Yes | Yes | Yes | Yes | Yes |
| Thermosetting organopolysiloxane layer (II) | No | No | No | No | No | No |
| Photosensitive organopolysiloxane layer (II) | No | No | No | No | No | No |
| Taber abrasion test | AA | AA | AA | AA | AA | AA |
| Super accelerated weathering test (cracking) | A | A | A | A | A | A |
| Super accelerated weathering test (whitening) | A | A | A | A | A | A |
| Super accelerated weathering test (yellowing) | A | A | A | A | A | A |
| Initial adhesion | A | A | A | A | A | A |
| Heat-resistant adhesion test | AA | A | AA | A | AA | AA |
| Water-resistant adhesion test | A | A | AA | A | AA | A |

[Table 15]

| Table 15 | Example 7 | Example 8 | Example 9 | Example 10 | Example 11 | Example 12 |
|---|---|---|---|---|---|---|
| Resin layer (I) | P-7 | P-8 | P-9 | P-10 | P-11 | P-1 |
| Vapor-deposited inorganic oxide layer (II) | Yes | Yes | Yes | Yes | Yes | No |
| Thermosetting organopolysiloxane layer (II) | No | No | No | No | No | Yes |
| Photosensitive organopolysiloxane layer (II) | No | No | No | No | No | No |
| Taber abrasion test | AA | AA | AA | AA | AA | A |
| Super accelerated weathering test (cracking) | A | A | A | A | A | A |
| Super accelerated weathering test (whitening) | AA | A | A | A | A | A |
| Super accelerated weathering test (yellowing) | A | A | A | A | A | A |
| Initial adhesion | A | A | A | A | A | A |
| Heat-resistant adhesion test | AA | AA | AA | A | AA | AA |
| Water-resistant adhesion test | AA | AA | AA | A | AA | A |

[Table 16]

| Table 16 | Example 13 | Example 14 | Example 15 | Example 16 |
|---|---|---|---|---|
| Resin layer (I) | P-1 | P-12 | P-13 | P-14 |
| Vapor-deposited inorganic oxide layer (II) | No | No | No | Yes |
| Thermosetting organopolysiloxane layer (II) | No | No | No | No |
| Photosensitive organopolysiloxane layer (II) | Yes | Yes | Yes | No |
| Taber abrasion test | A | A | A | AA |
| Super accelerated weathering test (cracking) | A | A | A | A |
| Super accelerated weathering test (whitening) | A | A | A | A |
| Super accelerated weathering test (yellowing) | A | A | A | A |
| Initial adhesion | A | A | A | A |
| Heat-resistant adhesion test | AA | AA | AA | A |
| Water-resistant adhesion test | A | AA | AA | A |

[Table 17]

| Table 17 | Comparative Example 1 | Comparative Example 2 | Comparative Example 3 | Comparative Example 4 | Comparative Example 5 | Comparative Example 6 | Comparative Example 7 |
|---|---|---|---|---|---|---|---|
| Resin layer (I) | Comparative P-1 | Comparative P-2 | P-1 | P-7 | Comparative P-4 | Comparative P-5 | Comparative P-6 |
| Vapor-deposited inorganic oxide layer (II) | Yes | Yes | No | No | No | No | No |
| Thermosetting organopolysiloxane layer (II) | No | No | No | No | No | No | No |
| Photosensitive organopolysiloxane layer (II) | No | No | No | No | Yes | Yes | Yes |
| Taber abrasion test | AA | AA | C | C | A | A | C |
| Super accelerated weathering test (cracking) | C | C | A | A | C | C | C |
| Super accelerated weathering test (whitening) | B | A | A | AA | B | B | C |
| Super accelerated weathering test (yellowing) | B | A | A | A | B | B | C |
| Initial adhesion | A | A | A | A | A | A | C |
| Heat-resistant adhesion test | C | C | AA | AA | C | C | C |
| Water-resistant adhesion test | C | B | A | AA | C | C | C |

[Table 18]

| Table 18 | Example 12 | Comparative Example 8 |
|---|---|---|
| Resin layer (I) | P-1 | Comparative P-2 |
| Cover glass (II) | Yes | Yes |
| Taber abrasion test | AA | AA |
| Super accelerated weathering test (cracking) | A | A |
| Super accelerated weathering test (yellowing) | A | A |
| Heat-resistant adhesion test [II] | A | C |
| Clouding test | AA | C |

As can be seen from the above results, in the layered bodies obtained in Examples 1 to 16, the abrasion resistance, the appearance after the weather resistance test, the yellowing, the heat-resistant adhesion, and the water-resistant adhesion were satisfactory. The layered body obtained in Comparative Example 1 is an example in which no vinyl-based polymer segment (a2) is used in the active energy ray-curable resin composition of the resin layer (I). In this case, cracking, whitening, and yellowing occurred in the weather resistance test, and the heat-resistant adhesion and the water-resistant adhesion were poor.

In the layered body obtained in Comparative Example 2, the vinyl-based polymer segment (a2) of the composite resin in the curable resin composition of the resin layer (I) is not bonded directly to the fine inorganic particles (m). Therefore, the heat-resistant adhesion and the water-resistant adhesion were poor.

In the layered bodies obtained in Comparative Examples 3 and 4, no second layer (II) is stacked. Therefore, although the adhesion was good, the abrasion resistance was very poor.

In the layered bodies obtained in Comparative Examples 5 and 6, no organopolysiloxane is present in the active energy ray-curable resin composition in the resin layer (I). Therefore, cracking, whitening, and yellowing occurred in the weather resistance test, and the heat-resistant adhesion and the water-resistant adhesion were poor.

In the layered body obtained in Comparative Example 7, no organopolysiloxane and no silane coupling agent are present in the active energy ray-curable resin composition in the resin layer (I). Therefore, cracking, whitening, and yellowing occurred in the weather resistance test, and the initial adhesion, the heat-resistant adhesion, and the water-resistant adhesion were poor.

Industrial Applicability

The layered body of the present invention is characterized by containing the fine inorganic particle composite (M) characterized in that, in the active energy ray-curable resin composition contained in the resin layer (I), the inorganic-organic composite resin is firmly bonded directly to the fine inorganic particles (m). Therefore, the resin layer (I) is excellent in abrasion resistance, long-term weather resistance (prevention of yellowing, adhesion), heat-resistant adhesion, and water-resistant adhesion and can be used preferably for, for example, building exteriors, window materials of mobile vehicles, light-receiving surfaces of solar batteries, etc.

## Claims

**1.** A layered body comprising a resin layer (I) and a second layer (II) that are stacked on one another,
wherein the resin layer (I) is formed of a resin composition containing a fine inorganic particle composite (M) that includes: a composite resin (A) in which a polysiloxane segment (a1) having a structural unit represented by general formula (1) and/or general formula (2) and further having a silanol group and/or a hydrolyzable silyl group is bonded to a vinyl-based polymer segment (a2) through a bond represented by general formula (4); and fine inorganic particles (m) that are each bonded to the composite resin (A) at the polysiloxane segment (a1) through a siloxane bond:

[Chem. 1]

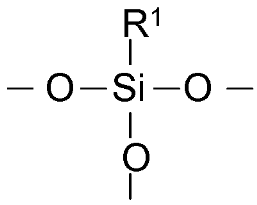

(1)

[Chem. 2]

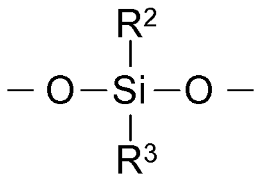

(2)

(wherein, in general formulas (1) and (2), $R^1$, $R^2$, and $R^3$ are each independently an alkyl group having 1 to 6 carbon atoms, a cycloalkyl group having 3 to 8 carbon atoms, an aryl group, an aralkyl group having 7 to 12 carbon atoms, an epoxy group, or a polymerizable double bond-containing group selected from the group consisting of $-R^4-CH=CH_2$, $-R^4-C(CH_3)=CH_2$, $-R^4-O-CO-C(CH_3)=CH_2$, $-R^4-O-CO-CH=CH_2$, and a group represented by formula (3) below (wherein $R^4$ represents a single bond or an alkylene group having 1 to 6 carbon atoms):

[Chem. 3]

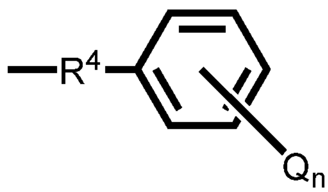

(3)

(wherein, in general formula (3), n is an integer from 1 to 5, and a structure Q represents one of $-CH=CH_2$ and $-C(CH_3)=CH_2$));

[Chem. 4]

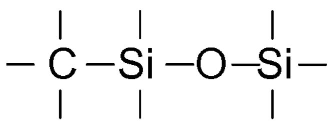

(4)

(wherein, in general formula (4), a carbon atom forms part of the vinyl-based polymer segment (a2), and a silicon atom bonded only to an oxygen atom forms part of the polysiloxane segment (a1)).

**2.** The layered body according to claim 1, wherein at least one of $R^1$, $R^2$, and $R^3$ is a polymerizable double bond-containing group.

**3.** The layered body according to claim 1 or 2, wherein the layered body further comprises a third layer (III), and the resin layer (I) and the second layer (II) are stacked in this order on the third layer (III).

**4.** The layered body according to claim 3, wherein the second layer (II) is an inorganic oxide layer.

**5.** The layered body according to claim 4, wherein the inorganic oxide layer is an inorganic oxide vapor-deposited film layer formed by a chemical vapor deposition method (a CVD method).

**6.** The layered body according to claim 4, wherein the inorganic oxide layer is a cured organopolysiloxane layer.

**7.** The layered body according to any of claims 1 to 6, wherein the fine inorganic particles (m) are formed of silica.

**8.** An adhesive comprising a fine inorganic particle composite (M) that includes: a composite resin (A) in which a polysiloxane segment (a1) having a structural unit represented by general formula (1) and/or general formula (2) and further having a silanol group and/or a hydrolyzable silyl group is bonded to a vinyl-based polymer segment (a2) through a bond represented by general formula (4); and fine inorganic particles (m) that are each bonded to the composite resin (A) at the polysiloxane segment (a1) through a siloxane bond:

[Chem. 5]

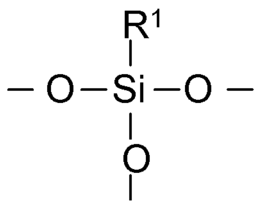

(1)

[Chem. 6]

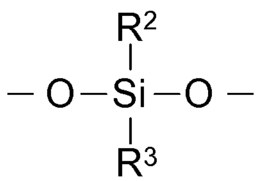

(2)

(wherein, in general formulas (1) and (2), $R^1$, $R^2$, and $R^3$ are each independently an alkyl group having 1 to 6 carbon atoms, a cycloalkyl group having 3 to 8 carbon atoms, an aryl group, an aralkyl group having 7 to 12 carbon atoms, an epoxy group, or a polymerizable double bond-containing group selected from the group consisting of $-R^4-CH=CH_2$, $-R^4-C(CH_3)=CH_2$,$-R^4-O-CO-C(CH_3)=CH_2$, $-R^4-O-CO-CH=CH_2$, and a group represented by formula (3) below (wherein $R^4$ represents a single bond or an alkylene group having 1 to 6 carbon atoms):

[Chem. 7]

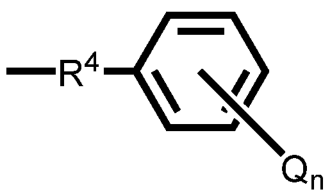

(3)

(wherein, in general formula (3), n is an integer from 1 to 5, and a structure Q represents one of $-CH=CH_2$ and $-C(CH_3)=CH_2$));

[Chem. 8]

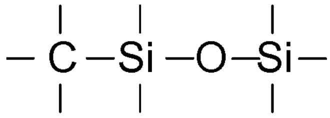

(4)

(wherein, in general formula (4), a carbon atom forms part of the vinyl-based polymer segment (a2), and a silicon atom bonded only to an oxygen atom forms part of the polysiloxane segment (a1)).

**9.** The adhesive according to claim 8, wherein at least one of $R^1$, $R^2$, and $R^3$ is a polymerizable double bond-containing group.

**10.** A primer comprising a fine inorganic particle composite (M) that includes: a composite resin (A) in which a polysiloxane segment (a1) having a structural unit represented by general formula (1) and/or general formula (2) and further having a silanol group and/or a hydrolyzable silyl group is bonded to a vinyl-based polymer segment (a2) through a bond represented by general formula (4); and fine inorganic particles (m) that are each bonded to the composite resin (A) at the polysiloxane segment (a1) through a siloxane bond:

[Chem. 9]

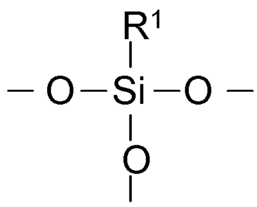

(1)

[Chem. 10]

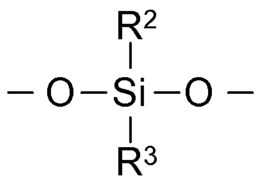

(2)

(wherein, in general formulas (1) and (2), $R^1$, $R^2$, and $R^3$ are each independently an alkyl group having 1 to 6 carbon atoms, a cycloalkyl group having 3 to 8 carbon atoms, an aryl group, an aralkyl group having 7 to 12 carbon atoms, an epoxy group, or a polymerizable double bond-containing group selected from the group consisting of $-R^4-CH=CH_2$, $-R^4-C(CH_3)=CH_2$, $-R^4-O-CO-C(CH_3)=CH_2$, $-R^4-O-CO-CH=CH_2$, and a group represented by formula (3) below (wherein $R^4$ represents a single bond or an alkylene group having 1 to 6 carbon atoms):

[Chem. 11]

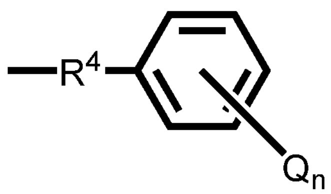

(3)

(wherein, in general formula (3), n is an integer from 1 to 5, and a structure Q represents one of $-CH=CH_2$ and $-C(CH_3)=CH_2$));

[Chem. 12]

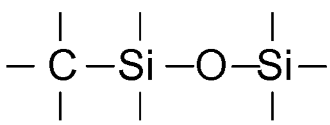

(4)

(wherein, in general formula (4), a carbon atom forms part of the vinyl-based polymer segment (a2), and a silicon atom bonded only to an oxygen atom forms part of the polysiloxane segment (a1)).

**11.** The primer according to claim 10, wherein at least one of $R^1$, $R^2$, and $R^3$ is a polymerizable double bond-containing group.

**Patentansprüche**

**1.** Schichtkörper, umfassend eine Harzschicht (I) und eine zweite Schicht (II), die übereinander gestapelt sind, wobei die Harzschicht (I) aus einer Harzzusammensetzung gebildet ist, die einen anorganischen Feinteilchenverbundstoff (M) enthält, der beinhaltet: ein Verbundharz (A), bei dem ein Polysiloxansegment (a1), das eine durch die allgemeine Formel (1) und/oder die allgemeine Formel (2) dargestellte Struktureinheit aufweist und das ferner eine Silanolgruppe und/oder eine hydrolysierbaren Silylgruppe aufweist, an ein Vinyl-basiertes Polymersegment (a2) durch eine durch die allgemeine Formel (4) dargestellte Bindung gebunden ist; und anorganische Feinteilchen (m), die jeweils an das Verbundharz (A) beim Polysiloxansegment (a1) durch eine Siloxanbindung gebunden sind:

[Chem. 1]

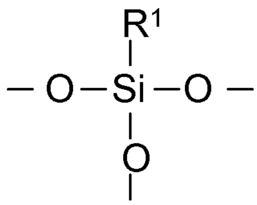

(1)

[Chem. 2]

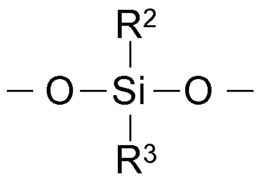

(2)

(wobei in den allgemeinen Formeln (1) und (2) $R^1$, $R^2$ und $R^3$ jeweils unabhängig voneinander eine Alkylgruppe mit 1 bis 6 Kohlenstoffatomen, eine Cycloalkylgruppe mit 3 bis 8 Kohlenstoffatomen, eine Arylgruppe, eine Aralkylgruppe mit 7 bis 12 Kohlenstoffatomen, eine Epoxygruppe, oder eine polymerisierbare Doppelbindung-enthaltende Gruppe ausgewählt aus der Gruppe bestehend aus $-R^4-CH=CH_2$, $-R^4-C(CH_3)=CH_2$, $-R^4-O-CO-C(CH_3)=CH_2$, $-R^4-O-CO-CH=CH_2$, und eine durch die folgende Formel (3) dargestellte Gruppe sind (wobei $R^4$ eine Einfachbindung oder eine Alkylengruppe mit 1 bis 6 Kohlenstoffatomen darstellt):

[Chem. 3]

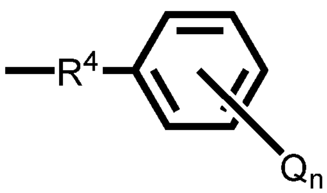

(3)

(wobei in der allgemeinen Formel (3) n eine ganze Zahl von 1 bis 5 ist und eine Struktur Q eines aus $-CH=CH_2$ und $-C(CH_3)=CH_2$ darstellt));

[Chem. 4]

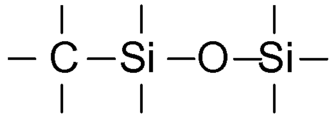

(4)

(wobei in der allgemeinen Formel (4) ein Kohlenstoffatom Teil des Vinylbasierten Polymersegments (a2) bildet und ein Siliciumatom, das nur an ein Sauerstoffatom gebunden ist, Teil des Polysiloxansegments (a1) bildet).

**2.** Schichtkörper nach Anspruch 1, wobei zumindest einer der Reste $R^1$, $R^2$ und $R^3$ eine polymerisierbare Doppelbindung-enthaltende Gruppe ist.

**3.** Schichtkörper nach Anspruch 1 oder 2, wobei der Schichtkörper ferner eine dritte Schicht (III) umfasst, und die Harzschicht (I) und die zweite Schicht (II) in dieser Reihenfolge auf der dritten Schicht (III) gestapelt sind.

**4.** Schichtkörper nach Anspruch 3, wobei die zweite Schicht (II) eine anorganische Oxidschicht ist.

**5.** Schichtkörper nach Anspruch 4, wobei die anorganische Oxidschicht eine dampfabgeschiedene anorganische Oxidschicht ist, die durch ein chemisches Dampfabschungsverfahren (ein CVD-Verfahren) gebildet wird.

**6.** Schichtkörper nach Anspruch 4, wobei die anorganische Oxidschicht eine gehärtete Organopolysiloxanschicht ist.

**7.** Schichtkörper nach einem der Ansprüche 1 bis 6, wobei die anorganischen Feinteilchen (m) aus Siliciumdioxid gebildet sind.

**8.** Haftmittel, umfassend einen anorganischen Feinteilchenverbundstoff (M), der beinhaltet: ein Verbundharz (A), bei dem ein Polysiloxansegment (a1), das eine durch die allgemeine Formel (1) und/oder die allgemeine Formel (2) dargestellte Struktureinheit aufweist und das ferner eine Silanolgruppe und/oder eine hydrolysierbaren Silylgruppe aufweist, an ein Vinyl-basiertes Polymersegment (a2) durch eine durch die allgemeine Formel (4) dargestellte Bindung gebunden ist; und anorganische Feinteilchen (m), die jeweils an das Verbundharz (A) beim Polysiloxansegment (a1) durch eine Siloxanbindung gebunden sind:

[Chem. 5]

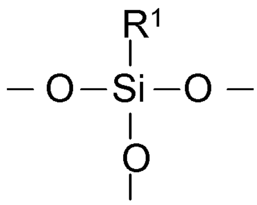

(1)

[Chem. 6]

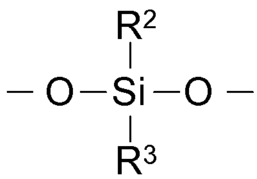

(2)

(wobei in den allgemeinen Formeln (1) und (2) $R^1$, $R^2$ und $R^3$ jeweils unabhängig voneinander eine Alkylgruppe mit 1 bis 6 Kohlenstoffatomen, eine Cycloalkylgruppe mit 3 bis 8 Kohlenstoffatomen, eine Arylgruppe, eine Aralkylgruppe mit 7 bis 12 Kohlenstoffatomen, eine Epoxygruppe, oder eine polymerisierbare Doppelbindung-enthaltende Gruppe ausgewählt aus der Gruppe bestehend aus $-R^4-CH=CH_2$, $-R^4-C(CH_3)=CH_2$, $-R^4-O-CO-C(CH_3)=CH_2$, $-R^4-O-CO-CH=CH_2$, und eine durch die folgende Formel (3) dargestellte Gruppe sind (wobei $R^4$ eine Einfachbindung oder

eine Alkylengruppe mit 1 bis 6 Kohlenstoffatomen darstellt):

[Chem. 7]

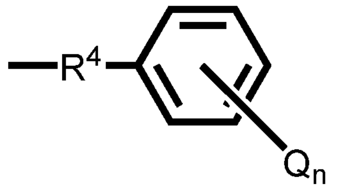

(3)

(wobei in der allgemeinen Formel (3) n eine ganze Zahl von 1 bis 5 ist und eine Struktur Q eines aus $-CH=CH_2$ und $-C(CH_3)=CH_2$ darstellt));

[Chem. 8]

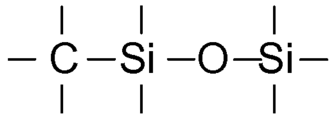

(4)

(wobei in der allgemeinen Formel (4) ein Kohlenstoffatom Teil des Vinylbasierten Polymersegments (a2) bildet und ein Siliciumatom, das nur an ein Sauerstoffatom gebunden ist, Teil des Polysiloxansegments (a1) bildet).

**9.** Haftmittel nach Anspruch 8, wobei zumindest einer der Reste $R^1$, $R^2$ und $R^3$ eine polymerisierbare Doppelbindung-enthaltende Gruppe ist.

**10.** Primer, umfassend einen anorganischen Feinteilchenverbund (M), der Folgendes beinhaltet: ein Verbundharz (A), bei dem ein Polysiloxansegment (a1), das eine durch die allgemeine Formel (1) und/oder die allgemeine Formel (2) dargestellte Struktureinheit aufweist und das ferner eine Silanolgruppe und/oder eine hydrolysierbaren Silylgruppe aufweist, an ein Vinyl-basiertes Polymersegment (a2) durch eine durch die allgemeine Formel (4) dargestellte Bindung gebunden ist; und anorganische Feinteilchen (m), die jeweils an das Verbundharz (A) beim Polysiloxansegment (a1) durch eine Siloxanbindung gebunden sind:

[Chem. 9]

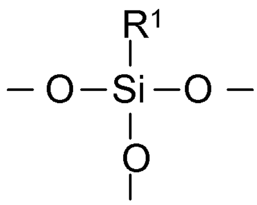

(1)

[Chem. 10]

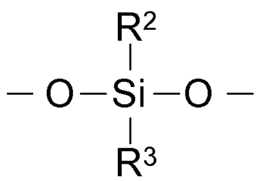

(2)

(wobei in den allgemeinen Formeln (1) und (2) $R^1$, $R^2$ und $R^3$ jeweils unabhängig voneinander eine Alkylgruppe mit 1 bis 6 Kohlenstoffatomen, eine Cycloalkylgruppe mit 3 bis 8 Kohlenstoffatomen, eine Arylgruppe, eine Aralkylgruppe mit 7 bis 12 Kohlenstoffatomen, eine Epoxygruppe, oder eine polymerisierbare Doppelbindung-enthaltende Gruppe ausgewählt aus der Gruppe bestehend aus $-R^4-CH=CH_2$, $-R^4-C(CH_3)=CH_2$, $-R^4-O-CO-C(CH_3)=CH_2$, $-R^4-O-CO-$

$CH=CH_2$, und eine durch die folgende Formel (3) dargestellte Gruppe sind (wobei $R^4$ eine Einfachbindung oder eine Alkylengruppe mit 1 bis 6 Kohlenstoffatomen darstellt):

[Chem. 11]

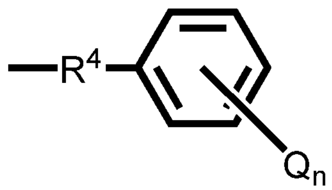

(3)

(wobei in der allgemeinen Formel (3) n eine ganze Zahl von 1 bis 5 ist und eine Struktur Q eines aus $-CH=CH_2$ und $-C(CH_3)=CH_2$ darstellt));

[Chem. 12]

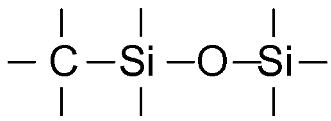

(4)

(wobei in der allgemeinen Formel (4) ein Kohlenstoffatom Teil des Vinylbasierten Polymersegments (a2) bildet und ein Siliciumatom, das nur an ein Sauerstoffatom gebunden ist, Teil des Polysiloxansegments (a1) bildet).

**11.** Primer nach Anspruch 10, wobei zumindest einer der Reste $R^1$, $R^2$ und $R^3$ eine polymerisierbare Doppelbindung-enthaltende Gruppe ist.

## Revendications

**1.** Corps stratifié comprenant une couche de résine (I) et une deuxième couche (II) qui sont empilées l'une sur l'autre, dans lequel la couche de résine (I) se compose d'une composition de résine contenant un composite (M) de particules inorganiques fines qui comprend : une résine composite (A) dans laquelle un segment polysiloxane (a1) ayant un motif structurel représenté par la formule générale (1) et/ou la formule générale (2) et ayant en outre un groupe silanol et/ou un groupe silyle hydrolysable est lié à un segment polymère à base de vinyle (a2) par le biais d'une liaison représentée par la formule (4) ; et des particules inorganiques fines (m) qui sont liées chacune à la résine composite (A) au niveau du segment polysiloxane (a1) par le biais d'une liaison siloxane :

[Formule chimique 1]

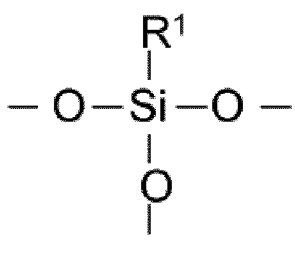

(1)

[Formule chimique 2]

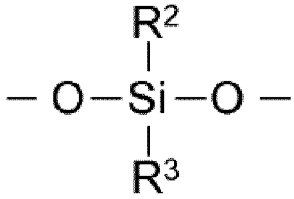

(2)

(dans lesquelles, dans les formules générales (1) et (2), $R^1$, $R^2$ et $R^3$ sont chacun indépendamment un groupe alkyle ayant de 1 à 6 atomes de carbone, un groupe cycloalkyle ayant de 3 à 8 atomes de carbone, un groupe aryle, un groupe aralkyle ayant de 7 à 12 atomes de carbone, un groupe époxy, ou un groupe contenant une double liaison polymérisable choisi dans le groupe constitué par $-R^4-CH=CH_2$, $-R^4-C(CH_3)=CH_2$, $-R^4-O-CO-C(CH_3)=CH_2$, $-R^4-O-CO-CH=CH_2$ et un groupe représenté par la formule (3) ci-dessous (dans laquelle $R^4$ représente une liaison simple ou un groupe alkylène ayant de 1 à 6 atomes de carbone) :

[Formule chimique 3]

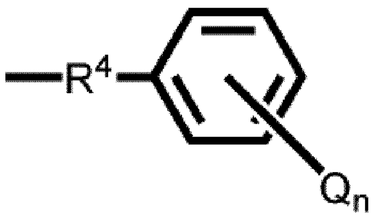

(3)

(dans laquelle, dans la formule générale (3), n est un nombre entier de 1 à 5, et une structure Q représente un de $-CH=CH_2$ et $-C(CH_3)=CH_2$)) ;

[Formule chimique 4]

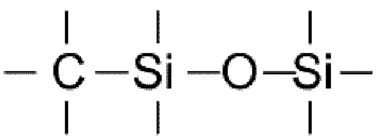

(4)

(dans laquelle, dans la formule générale (4), un atome de carbone forme une partie du segment polymère à base de vinyle (a2), et un atome de silicium lié uniquement à un atome d'oxygène forme une partie du segment polysiloxane (a1)).

2. Corps stratifié selon la revendication 1, dans lequel au moins un de $R^1$, $R^2$ et $R^3$ est un groupe contenant une double liaison polymérisable.

3. Corps stratifié selon la revendication 1 ou 2, dans lequel le corps stratifié comprend en outre une troisième couche (III) et la couche de résine (I) et la deuxième couche (II) sont empilées dans cet ordre sur la troisième couche (III).

4. Corps stratifié selon la revendication 3, dans lequel la deuxième couche (II) est une couche d'oxyde inorganique.

5. Corps stratifié selon la revendication 4, dans lequel la couche d'oxyde inorganique est une couche de film déposé en phase vapeur d'oxyde inorganique formée par une méthode de dépôt chimique en phase vapeur (une méthode CVD).

6. Corps stratifié selon la revendication 4, dans lequel la couche d'oxyde inorganique est une couche d'organopolysiloxane durcie.

**7.** Corps stratifié selon l'une quelconque des revendications 1 à 6, dans lequel les particules inorganiques fines (m) se composent de silice.

**8.** Adhésif comprenant un composite (M) de particules inorganiques fines qui comprend : une résine composite (A) dans laquelle un segment polysiloxane (a1) ayant un motif structurel représenté par la formule générale (1) et/ou la formule générale (2) et ayant en outre un groupe silanol et/ou un groupe silyle hydrolysable est lié à un segment polymère à base de vinyle (a2) par le biais d'une liaison représentée par la formule (4) ; et des particules inorganiques fines (m) qui sont liées chacune à la résine composite (A) au niveau du segment polysiloxane (a1) par le biais d'une liaison siloxane :

[Formule chimique 5]

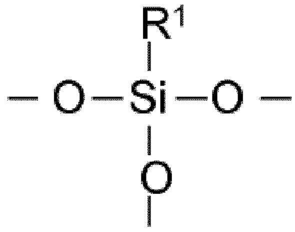
(1)

[Formule chimique 6]

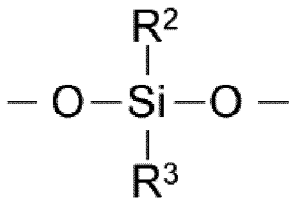
(2)

(dans lesquelles, dans les formules générales (1) et (2), $R^1$, $R^2$ et $R^3$ sont chacun indépendamment un groupe alkyle ayant de 1 à 6 atomes de carbone, un groupe cycloalkyle ayant de 3 à 8 atomes de carbone, un groupe aryle, un groupe aralkyle ayant de 7 à 12 atomes de carbone, un groupe époxy, ou un groupe contenant une double liaison polymérisable choisi dans le groupe constitué par $-R^4-CH=CH_2$, $-R^4-C(CH_3)=CH_2$, $-R^4-O-CO-C(CH_3)=CH_2$, $-R^4-O-CO-CH=CH_2$ et un groupe représenté par la formule (3) ci-dessous (dans laquelle $R^4$ représente une liaison simple ou un groupe alkylène ayant de 1 à 6 atomes de carbone) :

[Formule chimique 7]

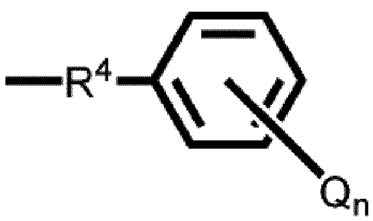
(3)

(dans laquelle, dans la formule générale (3), n est un nombre entier de 1 à 5, et une structure Q représente un de $-CH=CH_2$ et $-C(CH_3)=CH_2$)) ;

[Formule chimique 8]

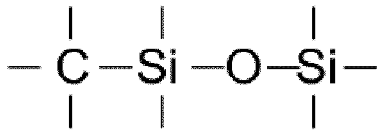

(4)

(dans laquelle, dans la formule générale (4), un atome de carbone forme une partie du segment polymère à base de vinyle (a2), et un atome de silicium lié uniquement à un atome d'oxygène forme une partie du segment polysiloxane (a1)).

**9.** Adhésif selon la revendication 8, dans lequel au moins un de $R^1$, $R^2$ et $R^3$ est un groupe contenant une double liaison polymérisable.

**10.** Amorce comprenant un composite (M) de particules inorganiques fines qui comprend : une résine composite (A) dans laquelle un segment polysiloxane (a1) ayant un motif structurel représenté par la formule générale (1) et/ou la formule générale (2) et ayant en outre un groupe silanol et/ou un groupe silyle hydrolysable est lié à un segment polymère à base de vinyle (a2) par le biais d'une liaison représentée par la formule (4) ; et des particules inorganiques fines (m) qui sont chacune liées à la résine composite (A) au niveau du segment polysiloxane (a1) par le biais d'une liaison siloxane :

[Formule chimique 9]

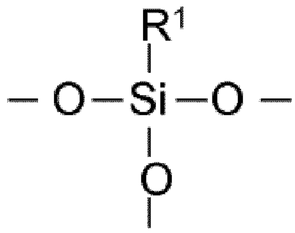

(1)

[Formule chimique 10]

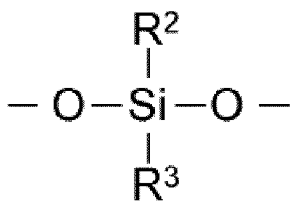

(2)

(dans lesquelles, dans les formules générales (1) et (2), $R^1$, $R^2$ et $R^3$ sont chacun indépendamment un groupe alkyle ayant de 1 à 6 atomes de carbone, un groupe cycloalkyle ayant de 3 à 8 atomes de carbone, un groupe aryle, un groupe aralkyle ayant de 7 à 12 atomes de carbone, un groupe époxy, ou un groupe contenant une double liaison polymérisable choisi dans le groupe constitué par $-R^4-CH=CH_2$, $-R^4-C(CH_3)=CH_2$, $-R^4-O-CO-C(CH_3)=CH_2$, $-R^4-O-CO-CH=CH_2$ et un groupe représenté par la formule (3) ci-dessous (dans laquelle $R^4$ représente une liaison simple ou un groupe alkylène ayant de 1 à 6 atomes de carbone) :

[Formule chimique 11]

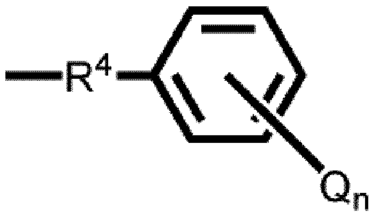

(3)

(dans laquelle, dans la formule générale (3), n est un nombre entier de 1 à 5, et une structure Q représente un de $-CH=CH_2$ et $-C(CH_3)=CH_2$)) ;

[Formule chimique 12]

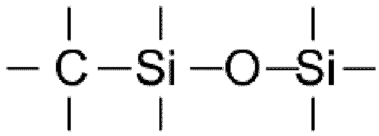

(4)

(dans laquelle, dans la formule générale (4), un atome de carbone forme une partie du segment polymère à base de vinyle (a2), et un atome de silicium lié uniquement à un atome d'oxygène forme une partie du segment polysiloxane (a1)).

**11.** Amorce selon la revendication 10, dans lequel au moins un de $R^1$, $R^2$ et $R^3$ est un groupe contenant une double liaison polymérisable.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2013035274 A
- JP 2013035275 A
- US 2013172463 A